# EUROPEAN PATENT SPECIFICATION

(11) **EP 4 451 333 B1**
(45) Date of publication and mention of the grant of the patent: **14.10.2026**
(21) Application number: 23214583.9
(22) Date of filing: 06.12.2023
(51) Int. Cl.: H10D 84/80, H10D 30/01, H10D 30/66, H10D 64/23, H10D 84/01

(54) **SEMICONDUCTOR STRUCTURE AND MANUFACTURING METHOD THEREOF**
HALBLEITERSTRUKTUR UND HERSTELLUNGSVERFAHREN DAFÜR
STRUCTURE SEMI-CONDUCTRICE ET SON PROCÉDÉ DE FABRICATION

(30) Priority: 21.04.2023 CN 202310440130
(43) Date of publication of application: 23.10.2024
(73) Proprietor: Diodes Incorporated, Plano, Texas 75024 (US)
(72) Inventor: CHUANG, Chiao-Shun, 231 New Taipei City (TW); KUO, TaChuan, 231 New Taipei City (TW)
(74) Representative: Marks & Clerk LLP

(56) References cited:
- DE-A1- 102016 120 772
- US-A1- 2003 178 676
- US-A1- 2004 185 622
- US-A1- 2010 044 788
- US-A1- 2012 193 748
- US-A1- 2012 256 193

## Description

### TECHNICAL FIELD

The present disclosure relates to the field of semiconductors, and more particularly, to a semiconductor structure and a manufacturing method thereof, only a semiconductor structure being claimed. A particular embodiment relates to a vertical power semiconductor structure having a RC (resistor-capacitor) snubber.

### BACKGROUND

Snubber circuits (or simply snubbers) are frequently used in electrical systems with inductive loads. In the electrical systems, a sudden interruption of the current flowing through a load causes sharp increase of voltage across a current switching device (or switching device). The resulting current transient may become a source of electromagnetic interference (EMI) in other circuits. In addition, if the voltage generated across a switching device exceeds what the switching device can tolerate, the switching device may be damaged or destroyed. A snubber provides an alternative current path around the switching device for a short period of time, allowing an inductive component to safely discharge.

RC (resistor-capacitor) snubbers are the fundamental components of switching circuits. They are generally used to control the EMI (electromagnetic interference) and the stress of excessive peak voltage generated during switching. For example, an RC snubber is a standard design element in various synchronous voltage converters and regulators. A simple RC snubber uses a resistor (R) connected in series with a capacitor (C). When switching on and off an inductive load using a direct current (DC) or alternating current (AC), a properly designed RC snubber can be used to limit the peak voltage across a switching device. The voltage across the capacitor does not change immediately, and so a reduced transient current will flow through the capacitor for a short period of time, which thus allows the voltage across the switching device to increase more slowly when the switching device is turned on.

An RC snubber is an external component, and is placed with a switching device in adjacent areas of a same PCB (printed circuit board). Thus, it needs to occupy an additional chip area, resulting in an increase in the total surface area of a device and an increase in the total process cost, which becomes a technical bottleneck in device miniaturization.

US 2010/044788 A1 discloses to a semiconductor device with a charge carrier compensation structure. The semiconductor device has a central cell field with a gate and source structure. At least one bond contact area is electrically coupled to the gate structure or the source structure. A capacitance-increasing field plate is electrically coupled to at least one of the nearsurface bond contact areas.

US 2004/185622 A1 discloses a trench-gated MOSFET formed using a super self aligned (SSA) process which employs an insulating layer such as a glass layer and a contact mask to define contact openings for electrical connections to source regions of the MOSFET. Using a contact mask and an intervening glass in otherwise self-aligned process reduces the coupling capacitance between source metal and the top of the embedded trench gate. A metal layer deposited to make electrical contact to source regions can be planarized to provide a flat surface to avoid formation of conductive traces that extend over the steps that the glass layer forms.

DE 10 2016 120772 A1 discloses a semiconductor device which includes a plurality of transistor cells (TC) having a gate electrode in a transistor cell region of a semiconductor region. A drain structure comprises a capacitor electrode region that directly borders a first surface of the semiconductor region in an inactive region that lies outside the transistor cell region and that is free of functional transistor cells. A gate connection directly connects a gate pad and the gate electrode. An integration layer between the gate pad and the semiconductor region is electrically connected to the gate pad and includes a region forming a capacitor electrode layer. A peripheral dielectric separates the capacitor electrode layer and the capacitor electrode region.

US 2012/193748 A1 discloses a trench-based power semiconductor device with increased breakdown voltage characteristics.

US 2012/256193 A1 discloses a semiconductor structure such as a power converter with an integrated capacitor.

US 2003/178676 A1 discloses a transistor configuration with a shielding electrode outside an active cell array and a reduced gate-drain capacitance. The shielding electrode is provided in an edge region and surrounds at least sections of an active cell array. The capacitance between an edge gate structure and a drain zone and hence the gate-drain capacitance CGD of the transistor configuration is reduced by the shielding electrode located in the edge region. The shielding electrode is connected to field electrodes below the gate electrodes in the gate trenches of the active call array.

### SUMMARY

The present invention is defined by the appended claims. Technical advantages are generally achieved, by embodiments of this disclosure which describe a semiconductor structure and an, unclaimed, manufacturing method thereof.

According to the invention, a semiconductor structure is provided that includes, among other features specified in claim 1: a substrate, comprising a first surface and a second surface opposite to each other, and comprising a unit region and a terminal region adjacent to each other in a top view of the substrate; a first electrode structure in the substrate and extending from the first surface toward the second surface, the first electrode structure being disposed in the unit region; a first trench structure in the substrate and extending from the first surface toward the second surface, the first trench structure disposed in the unit region and adjoining the terminal region, and the first trench structure comprising a first semiconductor material layer extended to the first surface; and a capacitive structure on the first surface of the substrate, the capacitive structure disposed in the terminal region and adjoining the first trench structure, wherein the capacitive structure has a material same as the first semiconductor material layer, the capacitive structure includes a first capacitive electrode and a second capacitive electrode, and the first capacitive electrode is connected to the first semiconductor material layer.

The semiconductor structure may further comprise a second trench structure in the substrate and extending from the first surface toward the second surface, the second trench structure being disposed in the terminal region and comprising a second semiconductor material layer that extends to the first surface, and the second capacitive electrode being connected to the second semiconductor material layer.

A bottom of the first electrode structure and a bottom of the first trench structure may be at about a same horizontal level.

The first electrode structure comprises a first gate electrode layer and a first shield electrode layer below the first gate electrode layer. The first trench structure comprises a second gate electrode layer adjacent to the first semiconductor material layer. A width of the first gate electrode layer is greater than a width of the second gate electrode layer.

A bottom of the first gate electrode layer and a bottom of the second gate electrode layer are at about a same horizontal level.

A first portion of the first semiconductor material layer is below the second gate electrode layer. A second portion of the first semiconductor material layer is connected to the first portion and disposed at a side of the second gate electrode layer.

The first portion may comprise a first sidewall and a second sidewall opposite to each other. The second portion may comprise a third sidewall and a fourth sidewall opposite to each other. The first sidewall and the third sidewall may be continuous sidewalls. The fourth sidewall may end on an upper surface of the first portion. The fourth sidewall and the second sidewall may be discontinuous sidewalls.

A width of the first portion of the first semiconductor material layer and a width of the first shield electrode layer are substantially equal. The width of the first portion of the first semiconductor material layer is greater than a width of the second portion of the first semiconductor material layer, wherein the width of the first and second gate electrode layers, the width of the first and second portions of the first semiconductor material layer, and the width of the first shield electrode layer are defined in a direction from the first electrode structure toward the first trench structure.

The upper surface of the first portion of the first semiconductor material layer may connect to the second portion of the first semiconductor material layer. The upper surface of the first portion of the first semiconductor material layer and an upper surface of the first shield electrode layer may be at about a same horizontal level.

The first electrode structure may comprise a first electrode material layer extending from the first surface toward the second surface. A width of the first semiconductor material layer at the first surface may be substantially equal to a width of the first electrode material layer at the first surface. A bottom of the first electrode material layer and a bottom of the first semiconductor material layer may be at about a same horizontal level.

A top surface of the first capacitive electrode may be substantially flush with a top surface of the second capacitive electrode.

A bottom surface of the first capacitive electrode on the first surface may be substantially flush with a bottom surface of the second capacitive electrode on the first surface.

A thickness of the first capacitive electrode on the first surface may be substantially equal to a thickness of the second capacitive electrode on the first surface.

The semiconductor structure may further comprise a conductive material layer above the capacitive structure, the conductive material layer overlapping at least one of the first capacitive electrode or the second capacitive electrode. The first capacitive electrode and the second capacitive electrode may comprise a semiconductor material including metal.

The semiconductor structure may further comprise a first conductive plug on the first capacitive electrode, the first conductive plug electrically connected to the first capacitive electrode. The semiconductor structure may further comprise a second conductive plug on the second capacitive electrode, the second conductive plug electrically connected to the second capacitive electrode.

The semiconductor structure may further comprise a third conductive plug extending from above the first surface toward the second surface, the third conductive plug disposed in the unit region and adjacent to the first electrode structure. A top surface of the third conductive plug and a top surface of the first conductive plug or the second conductive plug may be at about a same horizontal level.

The semiconductor structure may further comprise a fourth conductive plug extending from above the first surface toward the second surface, the fourth conductive plug disposed in the terminal region and adjacent to the second capacitive electrode. The second capacitive electrode may be electrically connected to the fourth conductive plug through a metal wire layer provided above the second conductive plug and the fourth conductive plug.

### BRIEF DESCRIPTION OF THE DRAWINGS

Aspects of embodiments of the present disclosure may be better understood from the following detailed description when read with accompanying drawings. It should be noted that various structures may not be drawn to scale. In fact, the dimensions of the various structures may be arbitrarily enlarged or reduced for clarity of discussion.

The technical solutions and beneficial effects of the present disclosure will be made apparent through the detailed description of embodiments of the present disclosure in conjunction with the accompanying drawings, in which:
FIG. 1 is a diagram of a cross sectional view of an example vertical power semiconductor device according to embodiments of the present disclosure;
FIG. 2 is a diagram of a top view of an example vertical power semiconductor device according to embodiments of the present disclosure;
FIG. 3 is a diagram of another top view of an example vertical power semiconductor device according to embodiments of the present disclosure;
FIGs. 4, 5, 6, 7, 8, 9, 10, 11, 12, 13, 14, 15, 16 and 17 are diagrams showing an example of one or more stages in a manufacturing method, which is not part of the claimed invention, of a vertical power semiconductor device according to embodiments of the present disclosure;
FIG. 18 is a diagram of a cross sectional view of an example vertical power semiconductor device in a manufacturing method, which is not part of the claimed invention, according to embodiments of the present disclosure;
FIGs. 19 and 20 are diagrams showing another example of one or more stages in a manufacturing method, which is not part of the claimed invention, of a vertical power semiconductor device according to embodiments of the present disclosure;
FIGs. 21 and 22 are diagrams showing another example of one or more stages in a manufacturing method of a vertical power semiconductor device according to embodiments of the present disclosure but not forming part of the claimed invention; and
FIGs. 23, 24 and 25 are diagrams of cross sectional views of example vertical power semiconductor devices in manufacturing methods according to embodiments of the present disclosure but not forming part of the claimed invention.

The same or similar components are labeled with the same reference numerals in the drawings and detailed description. Embodiments of the present disclosure will be readily understood from the following detailed description taken in conjunction with the accompanying drawings.

### DETAILED DESCRIPTION OF ILLUSTRATIVE EMBODIMENTS

The making and using of embodiments of this disclosure are discussed in detail below. It should be appreciated, however, that the concepts disclosed herein can be embodied in a wide variety of specific contexts, and that the specific embodiments discussed herein are merely illustrative and do not serve to limit the scope of the claims. Further, it should be understood that various changes, substitutions and alterations can be made herein without departing from the scope of this invention as defined by the appended claims.

The following disclosure provides various different embodiments or examples for implementing different features of the present disclosure. Specific embodiments of components and configurations are described below. Certainly, these are examples only and are not intended to be limiting. In this disclosure, references to forming a first feature over or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters in various embodiments. Such repetition is for simplicity and clarity and does not in itself indicate a relationship between the various embodiments and/or configurations discussed.

Embodiments of the present disclosure are discussed in detail below. It should be appreciated, however, that the present disclosure provides applicable concepts that can be embodied in a wide variety of specific contexts. The specific embodiments discussed herein are illustrative only, and do not limit the scope of the present disclosure.

Embodiments of the present disclosure provide a semiconductor structure and a manufacturing method thereof. Compared with general semiconductor power devices, an embodiment semiconductor power device of the present disclosure has an RC snubber structure formed in the same step of an electrode structure. An embodiment semiconductor structure manufacturing method of the present disclosure integrates the process of an RC snubber into the front-end process of semiconductor manufacturing. Compared with the method of separately manufacturing the RC snubber and the transistor chip and placing the RC snubber and the transistor chip adjacent to each other in the same PCB, the embodiment semiconductor structure manufacturing method can reduce the total device surface area and the total process cost.

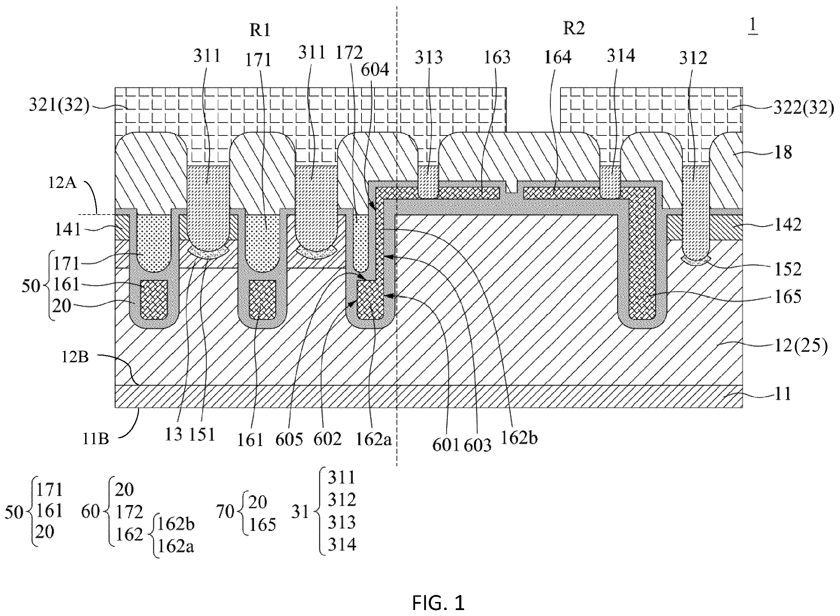

FIG. 1 is a cross sectional view of a vertical power semiconductor structure 1 according to certain embodiments of the present disclosure. The vertical power semiconductor structure 1 may include a semiconductor power device of various types or manufactured by various technologies. For example, the vertical power semiconductor structure 1 may include a power metal-oxide-semiconductor field-effect transistor (MOSFET), a double-diffused MOSFET (DMOSFET), an insulated-gate bipolar transistor (IGBT), or a junction gate field-effect transistor (JFET). Specifically, the vertical power semiconductor structure 1 may have a vertical current conduction path. For example, the current of the vertical power semiconductor structure 1 may flow in a direction that is perpendicular to the active surface of the vertical power semiconductor structure 1. In an example, the current of the vertical power semiconductor structure 1 may be conducted vertically passing through the vertical power semiconductor structure 1. It should be noted that the vertical power semiconductor structure 1 in FIG. 1 includes a split-gate vertical power semiconductor device formed in a unit region R1.

In some embodiments, the vertical power semiconductor structure 1 may include a semiconductor material layer 12, an electrode structure 50 (including an electrode material layer 161, a dielectric layer 20, and an electrode material layer 171), a trench structure 60 (including an electrode material layer 172, the dielectric layer 20, an electrode material layer 162), a capacitor structure (including capacitive electrodes 163, 164).

The semiconductor material layer 12 may include, for example, N-type or P-type single crystal silicon material, epitaxial silicon material, silicon carbide (SiC), Germanium (Ge), silicon germanium (SiGe), gallium nitride (GaN), gallium arsenide (GaAs), gallium arsenide phosphorus (GaAsP) or other semiconductor materials. In some embodiments, the semiconductor material layer 12 has epitaxial silicon material of a lightly doped region 25 of a first type. For the convenience of description, the N type will be used as an example of the first type in the following description. However, the present disclosure is not limited thereto, and the N type (first type) or the P type (second type) may be used for the semiconductor material layer 12 according to the conductivity type of the vertical power semiconductor structure 1.

The semiconductor material layer 12 may have a surface 12A and a surface 12B opposite to the surface 12A. In some embodiments, the surface 12A and the surface 12B may be located on an opposite side of a drain contact region 11. In some embodiments, the surface 12A and the surface 12B may be horizontal planes. For the convenience of description, the direction perpendicular to the surface 12A and the surface 12B is defined as the vertical direction, and the direction perpendicular to the vertical direction is defined as the horizontal direction. In some embodiments, the surface 12A may be an active surface of the semiconductor material layer 12. The semiconductor material layer 12 may also be referred to as a substrate.

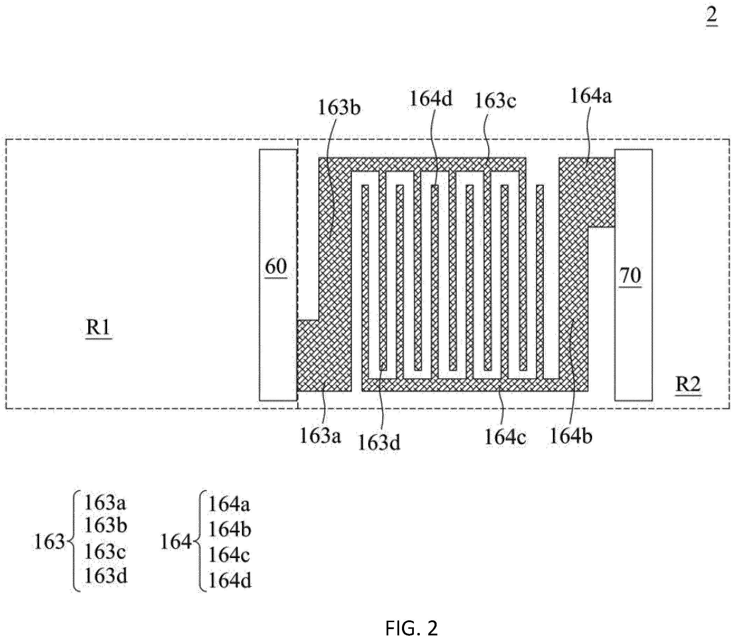

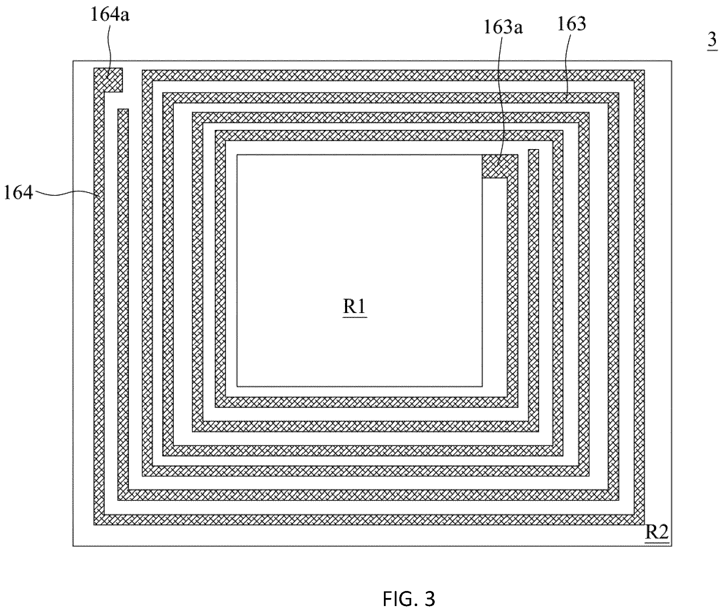

The unit region R1 and a terminal region R2 adjacent to each other are defined for the semiconductor material layer 12. The unit region R1 is used to accommodate active components, such as the above-mentioned vertical power semiconductor device. The terminal region R2 is used to accommodate passive components and may also be used to accommodate circuit terminals. In other words, active components are formed in the unit region R1 in subsequent steps, while passive components and optionally circuit terminals are formed in the terminal region R2 in subsequent steps. The terminal region R2 may adjoins at least one side of the unit region R1 (as shown in FIG. 2, which will be described later in detail). In some embodiments, the terminal region R2 surrounds the unit area R1 (as shown in FIG. 3, which will be described later in detail).

The electrode structure 50 is located in the semiconductor material layer 12 and extends from the surface 12A of the semiconductor material layer 12 toward the surface 12B. The electrode structure 50 is an electrode structure of a split-gate vertical power semiconductor device and is disposed in the unit region R1. In the embodiment shown in FIG. 1, the electrode structure 50, also known as a split-gate structure, includes the electrode material layer 171 close to the surface 12A, the electrode material layer 161 located below the electrode material layer 171, and the dielectric layer 20 surrounding the electrode material layer 171 and the electrode material layer 161. The dielectric layer 20 is used to electrically isolate the semiconductor material layer 12, the electrode material layer 161, and the electrode material layer 171. In other words, the dielectric layer 20 is located between the semiconductor material layer 12 and the electrode material layer 161, between the semiconductor material layer 12 and the electrode material layer 171, and between the electrode material layer 161 and the electrode material layer 171. In the claimed structure, the electrode material layer 171 functions as a gate electrode and is therefore called a gate electrode layer, and the electrode material layer 161 functions as a shield electrode, and is called a shield electrode layer. The vertical power semiconductor structure 1 may include multiple electrode structures 50, e.g., two electrode structures 50 adjacent to each other as shown in FIG. 1.

The trench structure 60 is located in the semiconductor material layer 12 and extends from the surface 12A of the semiconductor material layer 12 to the surface 12B. The trench structure 60 is disposed in the unit region R1 and adjoin the terminal region R2. Since the trench structure 60 may be formed in the same step as the electrode structure 50 (the relevant process will be described later in detail in conjunction with related figures), it may have a configuration/shape similar to the electrode structure 50. However, since the trench structure 60 does not have the function of splitting the gate electrode, the trench structure 60 is not considered as an electrode structure.

Taking the vertical power semiconductor structure 1 shown in FIG. 1 as an example, the trench structure 60 includes the electrode material layer 172 close to the surface 12A, the electrode material layer 162 extending from under the electrode material layer 172 to the surface 12A, and the dielectric layer 20 surrounding the electrode material layer 172 and the electrode material layer 162. The electrode material layer 162 has a first portion 162a located below the electrode material layer 172, and a second portion 162b connected to the first portion 162a and located along the side of the electrode material layer 172. The width of the electrode material layer 171 is greater than the width of the electrode material layer 172, which may be related to the trench structure 60 and the electrode structure 50 having the same width. In some embodiments, the first portion 162a has opposing sidewalls 601 and 602, the second portion 162b has opposing sidewalls 603 and 604, and the sidewalls 601 and 603 are continuous sidewalls. In some embodiments, the first portion 162a has an upper surface 605 connected to the second portion 162b. In some embodiments, the sidewall 604 ends at the upper surface 605 of the first portion 162a. In some embodiments, the sidewall 604 and the sidewall 602 are discontinuous sidewalls. In some embodiments, the upper surface 605 of the first portion 162a and an upper surface of the electrode material layer 161 are at approximately the same horizontal level. The width of the first portion 162a of the electrode material layer 162 is approximately equal to the width of the electrode material layer 161, and the width of the first portion 162a is greater than the width of the second portion 162b.

As described above, the trench structure 60 and the electrode structure 50 may be formed in the same step. Thus, the bottom of the electrode structure 50 and the bottom of the trench structure 60 may be located at about the same horizontal level. The bottom of the electrode material layer 171 and the bottom of the electrode material layer 172 are located at approximately the same horizontal level. In some embodiments, the electrode material layer 171 has material the same as that of the electrode material layer 172, such as metal material or other materials suitable for gate electrodes. In some embodiments, the bottom of the electrode material layer 161 and the bottom of the electrode material layer 162 may be located at about the same horizontal level. In some embodiments, the electrode material layer 162 has the same material as the electrode material layer 161, such as polysilicon material or other materials suitable for shield electrodes.

The capacitive structure includes the capacitive electrodes 163, 164. The capacitor structure is disposed on the surface 12A of the semiconductor material layer 12 in the terminal region R2, and adjoins the trench structure 60. In the embodiment as shown in FIG. 1, the capacitive electrode 163 is connected to the second portion 162b of the electrode material layer 162. The capacitive electrodes 163 and 164 may be formed in the same step, and the thickness of the capacitive electrode 163 at the surface 12A is approximately the same as the thickness of the capacitive electrode 164 at the surface 12A. In some embodiments, the top surface of the capacitive electrode 163 may be flush with the top surface of the capacitive electrode 164. In some embodiments, the bottom surface of the capacitive electrode 163 at the surface 12A may be flush with the bottom surface of the capacitive electrode 164 at the surface 12A. In some embodiments, the capacitive electrodes 163 and 164 may be formed in the same step as the electrode material layers 161 and 162. Therefore, the capacitive electrodes 163 and 164 may have the same material as the electrode material layers 161 and 162.

The vertical power semiconductor structure 1 also includes a trench structure 70 located in the semiconductor material layer 12 and extending from the surface 12A toward the surface 12B. The trench structure 70 may be disposed in the terminal region R2 and may function as an EQR (equipotential ring). In some embodiments, the trench structure 70 may include an electrode material layer 165 and the dielectric layer 20 surrounding the electrode material layer 165. The trench structure 70 may be formed in the same step as the electrode structure 50 and the trench structure 60. Specifically, the electrode material layer 165 may be formed in the same step as the electrode material layers 161, 162 and the capacitive electrodes 163, 164. Thus, the electrode material layer 165 may have the same material as the electrode material layer 161, 162 or the capacitive electrodes 163, 164. In some embodiments, the electrode material layer 165 may extend to the surface 12A, and the electrode material layer 165 may be connected to the capacitive electrode 164.

In addition to the lightly doped region 25, the vertical power semiconductor structure 1 may also have a plurality of doped regions 13, 141, 142, 151, 152, and a plurality of conductive plugs (such as conductive plugs 311, 312, 313, 314, hereinafter collectively referred to as conductive plugs 31).

The doped region 13 serves as the body doped region of the vertical power semiconductor structure 1 (hereinafter generally referred to as the body doped region 13). The body doped region 13 is located in the semiconductor material layer 12 that is adjacent to the electrode structure 50 and that is in the unit region R1, and the body doped region 13 is close to the surface 12A. In some embodiments, the body doped region 13 may be located between adjacent electrode structures 50, and between the electrode structure 50 and the trench structure 60. In some embodiments, the body doped region 13 may be located above the lightly doped region 25 and adjoin the lightly doped region 25. The body doped region 13 has a conductivity type, e.g., P type, that is different from the lightly doped region 25. The depth of the body doped region 13 may be smaller than the depth of the electrode structure 50.

The doped region 141 serves as the source (hereinafter generally referred to as the source doped region 141) of the split-gate vertical power semiconductor device, and is located in the body doped region 13 and close to the surface 12A of the semiconductor material layer 12. The depth of the source doped region 141 may be smaller than the depth of the body doped region 13, and the conductivity type of the source doped region 141 is different from that of the body doped region 13, such as N type. In some embodiments, the source doped region 141 may adjoin the surface 12A of the semiconductor material layer 12. In some embodiments, the doping concentration of the source doped region 141 may be greater than the doping concentration of the body doped region 13. In some embodiments, the electrode structure 50 extends in a vertical direction through the source doped region 141. In some embodiments, the source doped region 141 may be located between the adjacent electrode structures 50 as shown in FIG. 1.

The doped region 142 is located in the lightly doped region 25 of the terminal region R2, and is close to the surface 12A of the semiconductor material layer 12. The depth of the doped region 142 may be approximately the same as the depth of the source doped region 141, and has the same conductivity type as the source doped region 141, e.g., N type. A main function of the doped region 142 is to limit the expansion of the depletion region, and block external free electric charges or ions from entering the active area of the device, avoiding the normal electrical behavior from being affected. In some embodiments, the doped region 142 may adjoin the surface 12A of the semiconductor material layer 12. In some embodiments, the conductive plug 312 passes through the doped region 142. In some embodiments, the doped region 142 adjoins the trench structure 70 as shown in FIG. 1.

The doped region 151 is located in the body doped region 13 and serves as a heavily doped region in the body doped region 13 (hereinafter generally referred to as a heavily doped region 151). The heavily doped region 151 has the same conductivity type as the body doped region 13, such as P type. In some embodiments, the doping concentration of the heavily doped region 151 may be less than that of the source doped region 141 and greater than the doping concentration of the body doped region 13. In some embodiments, the heavily doped region 151 may be located in the body doped region 13 and separated from the lightly doped region 25. In some embodiments, the heavily doped region 151 may be separated from the source doped region 141. In some embodiments, the heavily doped region 151 may be disposed between adjacent electrode structures 50, and between the electrode structure 50 and the trench structure 60. The heavily doped region 151 may be separated from the electrode structure 50 and the trench structure 60 through portions of the body doped region 13. In other words, a portion of the body doped region 13 may be located between the heavily doped region 151 and the electrode structure 50, and another portion of the body doped region 13 may be located between the heavily doped region 151 and the trench structure 60. The heavily doped region 151 may surround the bottom of the conductive plug 311 placed in the body doped region 13, to reduce the ohmic contact resistance.

The doped region 152 (hereinafter generally referred to as the heavily doped region 152) is located in a heavily doped region in the lightly doped region 25 of the terminal region R2. The heavily doped region 152 has the same conductivity type as the heavily doped region 151, such as P type. In some embodiments, the doping concentration of the heavily doped region 152 is less than that of the source doped region 141 and greater than the doping concentration of the body doped region 13. In some embodiments, the heavily doped region 152 is located below the doped region 142 and is separated from the doped region 142. In some embodiments, the heavily doped region 151 is separated from the source doped region 141. In some embodiments, the heavily doped region 152 is close to the trench structure 70. The heavily doped region 152 may be separated from the trench structure 70 via a portion of the lightly doped region 25. The heavily doped region 151 may surround the bottom of the conductive plug 312 placed in the lightly doped region 25, to reduce the ohmic contact resistance.

The conductive plugs 31 extend from the above the surface 12A of the semiconductor material layer 12 toward the surface 12B in the vertical direction, and are connected to the heavily doped regions 151, 152 and the capacitive electrodes 163, 164 of the capacitor structure. The conductive plug 311 is provided in the unit region R1 between adjacent electrode structures 50, and between the electrode structure 50 and the trench structure 60. The conductive plug 311 may be electrically connected to the source electrode of the split-gate vertical power semiconductor device. The conductive plug 312 may be disposed in the terminal region R2. In some embodiments, the conductive plug 312 may be disposed to be adjacent to the trench structure 70. The conductive plug 312 may be electrically connected to the gain of the split-gate vertical power semiconductor device. The conductive plugs 313 and 314 are located on the capacitor structure, and connected to the capacitive electrodes 163 and 164, respectively. In some embodiments, the conductive plug 313 is connected to the capacitive electrode 163, and the conductive plug 314 is connected to the capacitive electrode 164. Since the conductive plugs 31 may be formed in the same steps, the top surfaces of the conductive plugs 311, 312, 313, 314 may be located at approximately the same horizontal level.

The vertical power semiconductor device 1 may also include the drain contact region 11, an interlayer dielectric layer 18, and a metal layer 32.

The drain contact region 11 is located on the surface 12B for contacting a drain metal layer (not shown, which may be formed on a surface 11B to be in contact with the drain contact region 11, and as a metal layer of a drain function). The drain contact region 11 has the doping of the same conductivity type as the lightly doped region 25. The drain contact region 11 may be disposed on an upper surface close to a silicon wafer or a substrate of other semiconductor materials. In some embodiments, the drain contact region 11 may be part of the silicon wafer or the substrate. The material of the drain contact region 11 may be, e.g., single crystal silicon material, epitaxial silicon material, silicon carbide (SiC), germanium (Ge), silicon germanium (SiGe), gallium nitride (GaN), gallium arsenide (GaAs), gallium arsenide phosphorus (GaAsP), or other semiconductor materials. In some embodiments, the doping concentration of the drain contact region 11 may be greater than that of the lightly doped region 25.

The interlayer dielectric layer 18 is located on the surface 12A of the semiconductor material layer 12, to separate the metal layer 32 in the interlayer dielectric layer 18 from the semiconductor material layer 12. In some embodiments, the conductive plugs 31 penetrate through the interlayer dielectric layer 18. In some embodiments, the metal layer 32 may be a patterned metal wire layer used to adjust electrical paths according to actual operating requirements, and including multiple metal wires connected to different conductive plugs 31. In some embodiments, the metal layer 32 may be a first metal layer (M1) of an interconnect structure. In some embodiments, the metal layer 32 may include a metal wire 321 connecting the conductive plugs 311 and 313, such that the electrode capacitance 163 and the source of the split-gate vertical power semiconductor device have equal potential. In some embodiments, the metal layer 32 includes a metal wire 322 connecting the conductive plugs 312 and 314, such that the electrode capacitance 164 and the drain of the split-gate vertical power semiconductor device have the same potential.

FIG. 2 and FIG. 3 are respective top views of vertical power semiconductor structures 2 and 3 according to different embodiments of the present disclosure, showing different configurations that the capacitor structure can have. It should be noted that the configurations of the capacitor structure shown in FIGs. 2 and 3 are for illustration only, and are not intended to limit the present disclosure.

As shown in FIG. 2, in some embodiments, the terminal region R2 adjoins only one side of the unit region R1. Therefore, the capacitor structure is provided on one side of the semiconductor power device in the unit region R1. The configuration of the capacitor structure may be adjusted based on different implementation methods and different requirements. For example, the capacitive electrodes 163 and 164 may be interdigitated electrodes, as shown in the top view of FIG. 2. The capacitive electrode 163 may have a contact point 163a located at one end of the capacitive electrode 163. In some embodiments, the contact point 163a is connected to the trench structure 60 that is in the unit region R1 and that adjoins the terminal region R2 (e.g., the first portion 162a of the trench structure 60 in FIG. 1). The capacitive electrode 164 may have a contact point 164a. The contact point 164a is located at one end of the capacitive electrode 164 and is arranged opposite to the contact point 163a. In some embodiments, the contact point 164a is connected to the trench structure 70 in the terminal region R2 (e.g., the electrode material layer 165 of the trench structure 70 in FIG. 1).

As shown in FIG. 3, in some embodiments, the terminal region R2 may surround the unit region R1. Therefore, the capacitor structure may be designed as a semiconductor power devices surrounding the unit region R1. The configuration/shape of the capacitor structure can be adjusted according to different implementation methods and different needs. For example, the capacitive electrode 163 may be a spiral electrode extending outward from the unit region R1. The capacitive electrode 164 may have a spiral configuration similar to the capacitive electrode 163 and is provided alternately with the capacitive electrode 163, as shown in the top view of FIG. 3. The capacitive electrode 163 as shown in FIG. 3 may have a contact pad 163a located at one end of the capacitive electrode 163. In some embodiments, the contact pad 163a is connected to the trench structure in the unit region R1 that adjoins the terminal region R2 (not shown in FIG. 3, and please refer to the first portion 162a of the trench structure 60 in FIG. 1). The capacitive electrode 164 may have a contact pad 164a, which is located at one end of the capacitive electrode 164 relative to the contact pad 163a. In some embodiments, the contact pad 164a is connected to the trench structure 70 in the terminal region R2 (not shown in FIG. 3, please refer to the electrode material layer 165 of the trench structure 70 in FIG. 1).

With the above-described inventive concept, the configuration/shape of the capacitor structure may be adjusted according to requirements such as chip area, capacitance, resistance, and so on. For example, the capacitive electrode may also be fishbone-shaped, dendritic-shaped, combshaped, and so on. Further, in order to facilitate calculation of resistance values, different portions of the capacitive electrodes 163, 164 may have different widths. As shown in FIG. 2, the capacitive electrode 163 has an electrode bus bar 163b connected to the contact pad 163a, a combiner bus 163c connected to the electrode bus bar 163b, and a finger-shaped portion 163d connected to the combiner bus 163c. The width of the electrode bus bar 163b is greater than the width of the combiner bus 163c or the width of the finger-shaped portion 163d. By adjusting the width of the electrode bus bar 163b so that the resistance value of the electrode bus bar 163b has a large proportion in the resistance value of the capacitive electrode 163, the resistance value of the electrode bus bar 163b can be used to roughly determine the resistance value of the capacitive electrode 163.

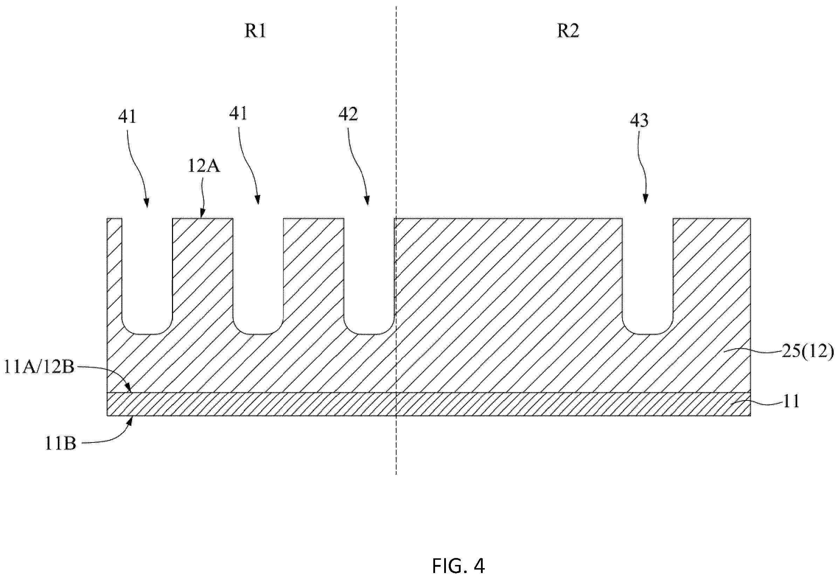

FIG. 4 to FIG. 17 illustrate an example of one or more stages in a manufacturing method of a vertical power semiconductor device according to certain embodiments of the present disclosure. At least some of the figures have been simplified to facilitate better understanding of aspects of the present disclosure. The method shown in FIG. 4 to FIG. 17 is not part of the claimed invention, but the structure resulting from the method is a device according to the claimed invention of this application.

Referring to FIG. 4, the manufacturing method includes performing epitaxial growth on a surface 11A of the drain contact region 11 to form the semiconductor material layer 12. The drain contact region 11 may be located on a top surface adjacent to a substrate or a silicon wafer, and have the surface 11A and the surface 11B opposite to the surface 11A. In some embodiments, the surface 11A is the top surface of the substrate or the silicon wafer. In some embodiments, the surface 11B of the drain contact region 11 may be located in the substrate or silicon wafer. In some embodiments, ions having N-type electrical properties may be implanted during the epitaxial growth to form an N-type semiconductor material layer 12, and the lightly doped region 25 may be formed without the need of performing additional ion implantation. In some embodiments, the semiconductor material layer 12 may have the surface 12A and the surface 12B opposite to the surface 12A. In some embodiments, the surface 12A and the surface 12B may be located on an opposite side of the drain contact region 11. In some embodiments, the surface 12A and the surface 12B may be horizontal surfaces. In some embodiments, the surface 12A may be the active surface of the semiconductor material layer 12. In some embodiment, the surface 12B of the semiconductor material layer 12 is in contact with the surface 11A of the drain contact region 11.

Trenches 41, 42, and 43 may be formed in the semiconductor material layer 12, and extend respectively from the surface 12A toward the surface 12B. The trenches 41 and 42 are located in the unit region R1, and the trench 43 is located in the terminal region R2. The trench 42 represents a trench in the unit region R1 that adjoins the terminal region R2. The trench(es) 41 represent trench(es) in the unit region R1 other than the trench 42. The unit region R1 and terminal region R2 may be two regions adjacent to each other when viewed in a top view, as shown in the previously described FIG. 2 or FIG. 3. The trenches 41, 42, 43 may have vertical sidewalls. The trenches 41, 42, 43 may have arc-shaped bottom surfaces. In addition, the trenches 41, 42, 43 may also be circular, oval, rectangular or polygonal. The trenches 41, 42, 43 may be positioned and patterned through photoresist, and then formed through an etching process (such as a plasma dry etching process). In some embodiments, a sidewall of the trench 42 may be aligned with a border line of the unit region R1 and the terminal region R2. In some embodiments, the bottoms of the trenches 41, 42, 43 may be at approximately the same horizontal level.

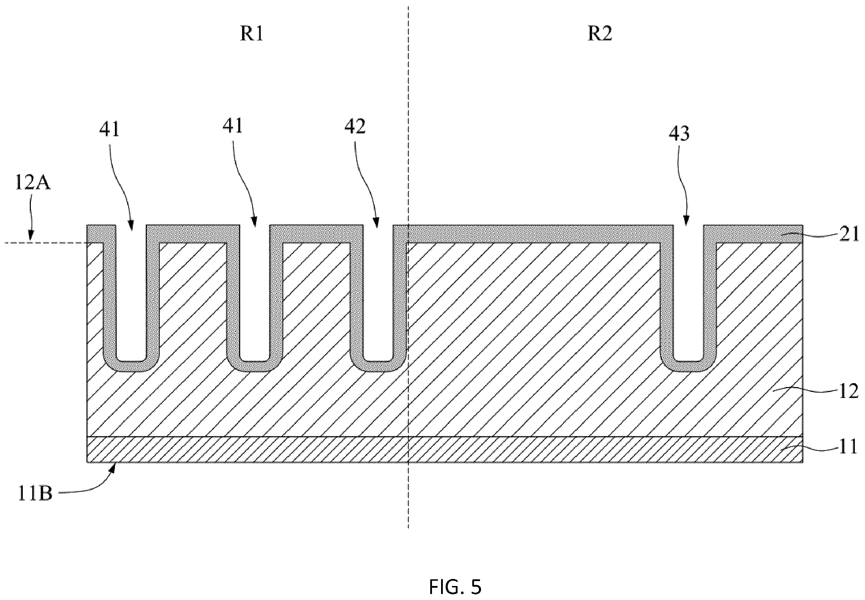

Referring to FIG. 5, the manufacturing method includes forming the dielectric layer 21 on the semiconductor material layer 12. In some embodiments, the dielectric layer 21 may cover the surface 12A of the semiconductor material layer 12 and underlie the trenches 41, 42, and 43. The dielectric layer 21 may be formed through atomic layer deposition (ALD), chemical vapor deposition (CVD) or other deposition processes. In some embodiments, the dielectric layer 21 may be formed through the thermal oxidation technology. In some embodiments, the dielectric layer 21 may be conformally deposited on the inner surfaces of the trenches 41, 42, 43 (including the opposite sidewalls and extending on the bottom between the sidewalls).

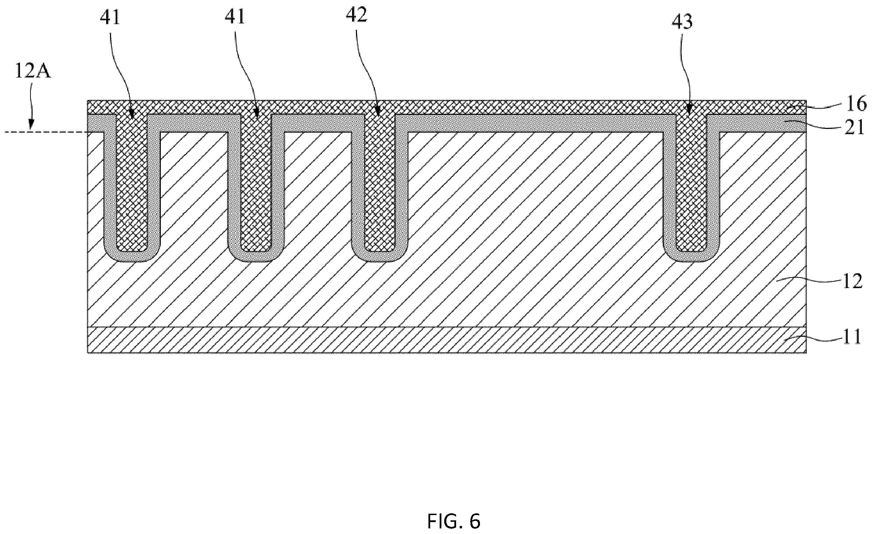

Referring to FIG. 6, the manufacturing method includes forming the electrode material layer 16 after the dielectric layer 21 is formed. In some embodiments, the dielectric layer 21 may be provided to fill the trenches 41, 42, and 43 and cover the surface 12A of the semiconductor material layer 12. The dielectric layer 21 may surround the electrode material layer 16 in the trenches 41, 42, 43. In some embodiments, the electrode material layer 16 may be formed through the physical vapor deposition (PVD), such as sputtering or spraying. In some embodiments, the electrode material layer 16 may be formed through electroplating or CVD. In some embodiments, after electroplating or deposition, a grinding process, such as a chemical mechanical polishing (CMP) process, may be performed on the electrode material layer 16, so that the electrode material layer 16 has a flat top surface. In some embodiments, the electrode material layer 16 includes polysilicon or conductive material.

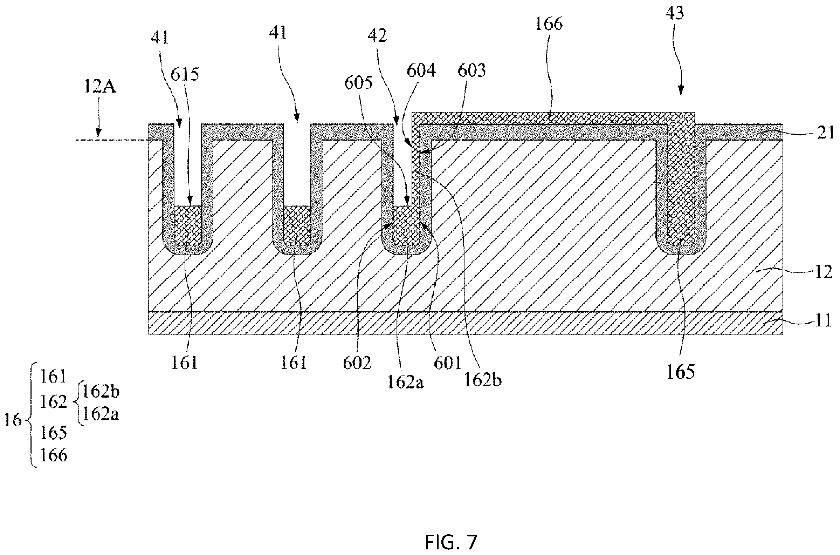

Referring to FIG. 7, the manufacturing method includes performing a first etching process to the electrode material layer 16 to remove at least part of the electrode material layer 16 on the surface 12A of the semiconductor material layer 12 in the unit region R1. In some embodiments, before performing the first etching process, a patterned photomask may be formed on the electrode material layer 16 to define portion(s) of the electrode material layer 16 to be removed by the first etching process. The first etching process may remove a portion of the electrode material layer 16 located in the trench(es) 41, a portion of the electrode material layer 16 located in the trench 42, a portion of the electrode material layer 16 on the surface 12A of the semiconductor material layer 12 in the unit region R1, and a portion of the electrode material layer 16 that is on the surface 12A of the semiconductor material layer 12 in the terminal region R2 and that is outside the capacitor structure region. It should be noted that the first etching process may include one or more etching steps, which is not limited in the present disclosure.

The electrode material layer 16, which after the first etching process is performed to, includes a first portion 161 located in the trenches 41, a second portion 162 located in the trench 42, a third portion 166 located on the surface 12A of the semiconductor material layer 12 and connected to the second portion 162, and a fourth portion 165 located in the trench 43.

The first portion 161 is located at the bottom of the trenches 41 and serves as a shield electrode for a semiconductor power device formed thereafter. The second portion 162 includes a lower portion 162a located at the bottom of the trench 42, and an upper portion 162b that covers a sidewall of the trench 42 adjoining the terminal region R2. The upper portion 162b is located on the lower portion 162a and is connected to an upper surface 605 of the lower portion 162a. The lower portion 162a of the second portion 162 and the first portion 161 are etched through the same first etching process, and thus, an upper surface 615 of the first portion 161 and the upper surface 605 of the lower portion 162a of the second portion 162 may be located at approximately the same horizontal level. In some embodiments, the first etching process may cause exposure of a portion of the dielectric layer 21 located above the upper surface 615 of the first portion 161 in the trenches 41. The upper portion 162b of the second portion 162 covers a portion of the dielectric layer 21 that is located in the trench 42 and adjacent to the terminal region R2. Therefore, in some embodiments, a portion of the dielectric layer 21, which is located above the upper surface 605 of the lower portion 162a in the trench 42 and on a sidewall of the trench 42 away from the terminal region R2, is exposed.

The second portion 162 of the electrode material layer 16 after being etched has a configuration/shape as described above with respect to FIG. 1. The lower portion 162a may have opposing sidewalls 601 and 602, and the upper portion 162b may have opposing sidewalls 603 and 604. In some embodiments, the sidewall 601 and sidewall 603 may be continuous side walls. In some embodiments, the upper portion 162b may be connected to the upper surface 605 of the lower portion 162a. In some embodiments, the sidewall 604 may end at the upper surface 605 of lower portion 162a. In some embodiments, the sidewall 604 and the sidewall 602 may be discontinuous side walls. In some embodiments, the width of the lower portion 162a of the second portion 162 is approximately the same as the width of the first portion 161, and the width of the lower portion 162a is greater than the width of the upper portion 162b.

The third portion 166 may cover the surface 12A of the semiconductor material layer 12 located in the terminal region R2 and between the trenches 42, 43. The third portion 166 will be patterned into the capacitive electrodes 163, 164 in subsequent steps. The fourth portion 165 is located in the trench 43. In some embodiments, the fourth portion 165 may fill up the trench 43. In some embodiments, the third portion 166 may be connected to the fourth portion 165 and the upper portion 162b of the second portion 162. In some embodiments, the patterned photomask described above may be removed after the first etching process is performed. In some embodiments, the third portion 166 may still have a flat top surface after the first etching process is performed.

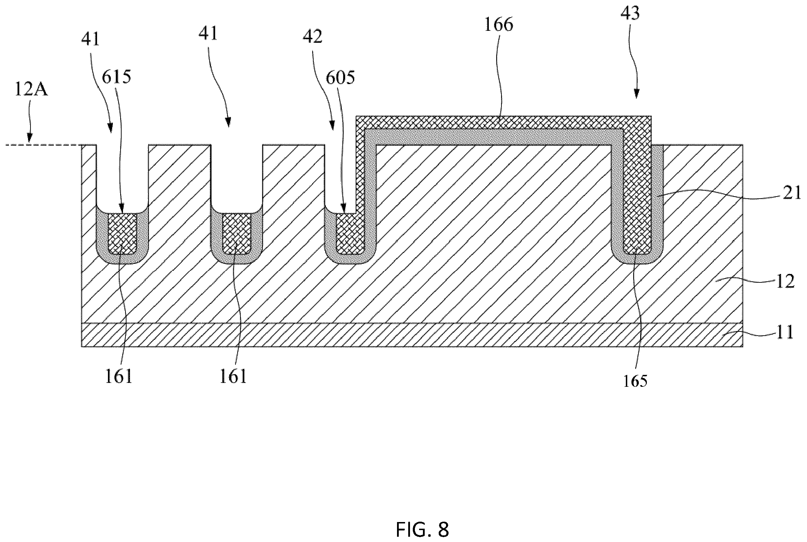

Referring to FIG. 8, the manufacturing method includes performing a second etching process to the dielectric layer 21, to remove a portion of the dielectric layer 21 that is located in the trenches 41 and 42 and above the first portion 161 and above the lower portion 162a of the second portion 162, and to remove a portion of the dielectric layer 21 that is on the surface 12A of the semiconductor material layer 12 and that is not covered by the third portion 166. In some embodiments, the second etching process causes exposure of the sidewalls of the trenches 41 above the first portion 161. In some embodiments, the second etching process causes exposure of partial sidewalls of the trench 42 that are above the lower portion 162a and away from the terminal region R2. In some embodiments, after the second etching process is performed, the portion of the dielectric layer 21 in the trench 43 may be completely retained.

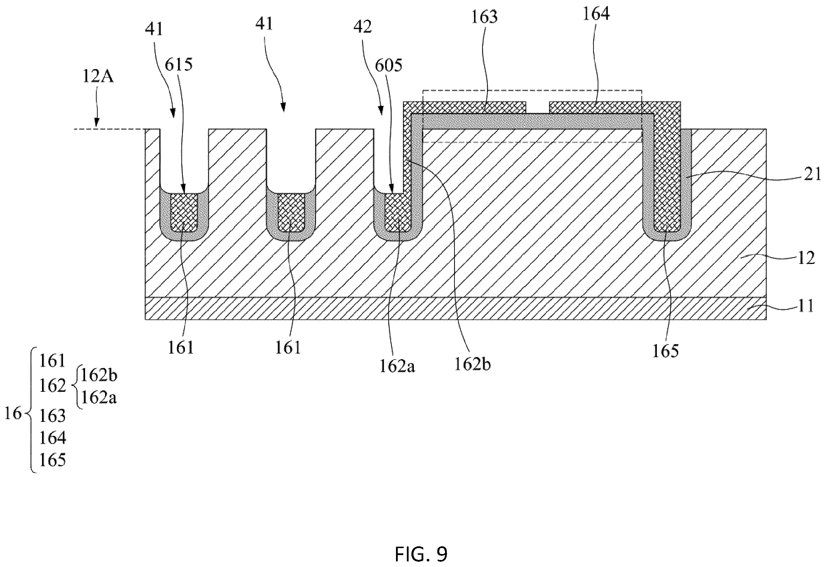

Referring to FIG. 9, the manufacturing method includes performing a third etching process to the third portion 166 to form the capacitive electrode 163, 164. The configurations/shapes of the capacitive electrodes 163 and 164 may be adjusted according to a resistance value and a capacitance value required. For example, the capacitive electrodes 163 and 164 in an area marked with a dashed block in FIG. 9, in a top view, may have the configurations/shapes as shown in FIG. 2 or FIG. 3. In other words, the capacitance value and resistance value of the capacitor structure may be defined based on the capacitive electrodes 163 and 164, and will not change with the operating voltage. In some embodiments, the upper surfaces of the capacitive electrodes 163, 164 may be located at approximately the same horizontal level. In some embodiments, before performing the third etching process, a patterned photomask having a pattern corresponding to the capacitive electrodes 163, 164 may be formed to cover the third portion 166, and the third etching process is performed using the patterned photomask as a mask. In some embodiments, after the third etching process is perform, the above-mentioned patterned photomask is removed.

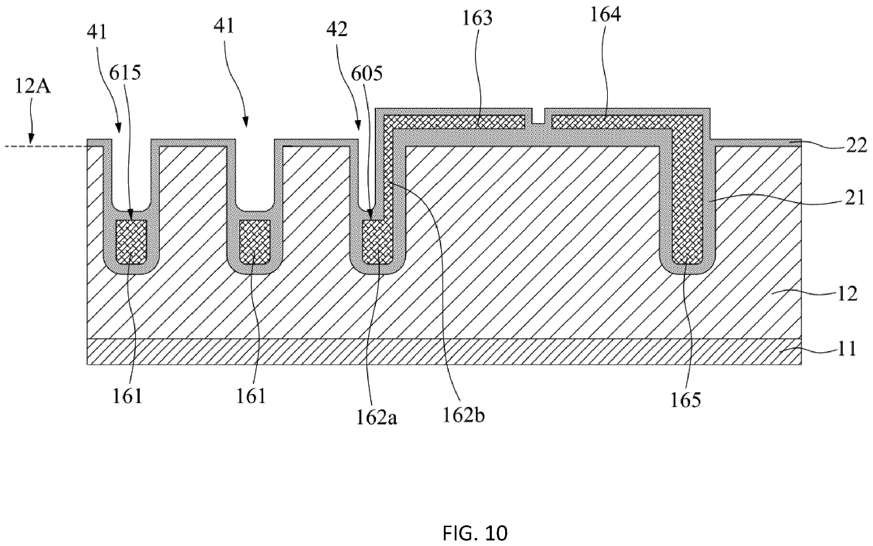

Referring to FIG. 10, the manufacturing method includes conformally forming the dielectric layer 22 on the semiconductor material layer 12 and the electrode material layer 16. In some embodiments, the thickness of the dielectric layer 22 is less than the thickness of the dielectric layer 21. Considering the operating voltage, the dielectric layer 21 may need to have a thickness large enough for having sufficient voltage withstand capability. The dielectric layer 22 may serve as a gate dielectric layer of a gate electrode to be formed in subsequent step(s), and therefore, the dielectric layer 22 may have a smaller thickness compared to the dielectric layer 21.

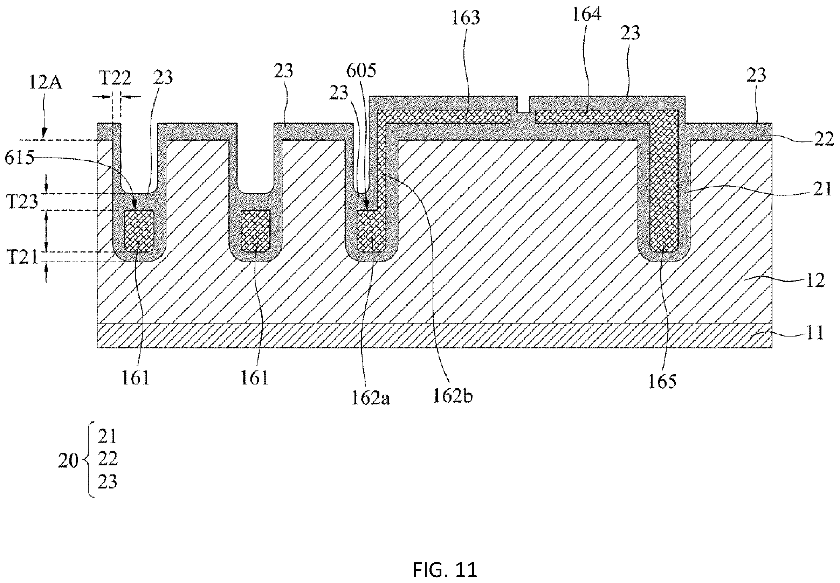

Referring to FIG. 11, the manufacturing method includes forming a dielectric layer 23 on the planar part of the dielectric layer 22. The dielectric layer 23 may only be formed on the planar part of the dielectric layer 22 and not on the vertical part of the dielectric layer 22, by controlling process parameters and process conditions of deposition. The thickness of the dielectric layer 22 may not be sufficiently large so as to electrically isolate the shield electrode and the gate electrode to be formed later, and thus, additional steps may be needed to increase the thickness of the planar part of the dielectric layer 22, in particular, the thickness of the bottom of the dielectric layer 22 in the trenches 41, 42, that is, the planar portion of the dielectric layer 22 on the upper surfaces 615, 605 of the electrode material layer 16 located in the trenches 41, 42. Therefore, the dielectric layer 23 may be formed on the bottom of the dielectric layer 22 in the trenches 41, 42 (i.e., on the upper surface 615 of the first portion 161, and on the upper surface 605 of the lower portion 162a of the second portion 162), on the top surface of the capacitive electrode 163, on the top surface of the capacitive electrode 164, on the dielectric layer 22 exposed by the capacitive electrode 163 and 164, and on the surface 12A of the semiconductor material layer 12. In some embodiments, the thickness T21 of the dielectric layer 21 may be greater than a thickness T23, which is the sum of the thicknesses of the dielectric layer 22 and the dielectric layer 23. In some embodiments, the thickness of the dielectric layer 23may be greater than the thickness T22 of the dielectric layer 22.

In some embodiments, the dielectric layers 21, 22, 23 may have the same dielectric material. To simplify the drawings, the dividing lines between the dielectric layers 21, 22 and 23 are omitted in the subsequent figures, and the dielectric layers 21, 22 and 23 are collectively referred to as a dielectric structure 20 or the dielectric layer 20. In some embodiments, the dielectric structure 20 located in the trenches 41, 42, 43 is referred to as an in-trench dielectric layer.

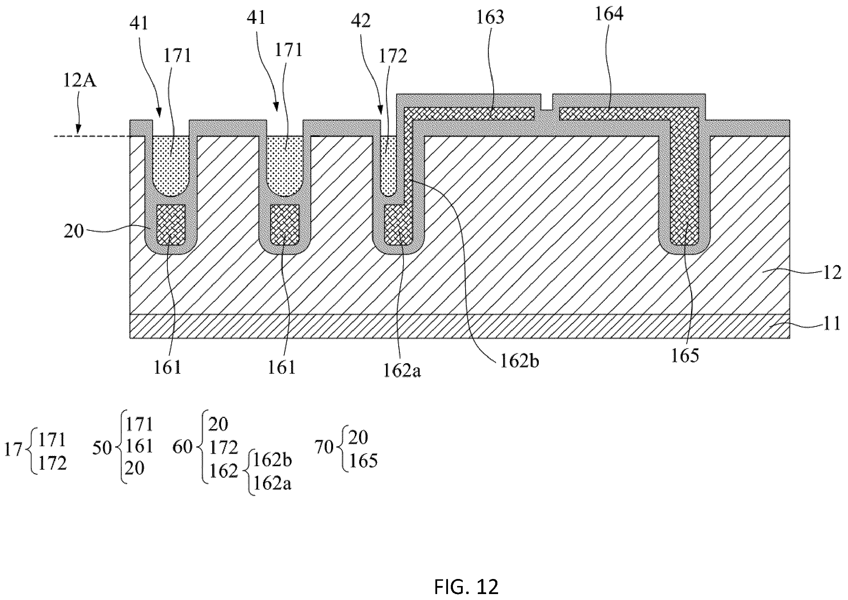

Referring to FIG. 12, the manufacturing method includes forming the electrode material layer 17 in the trenches 41 and the trench 42. The electrode material layer 17 includes first portion(s) 171 formed in the trenches 41 and a second portion 172 formed in the trench 42. As described above, since the electrode material layer 16 is only located at the bottom of the trenches 41, the first portion(s) 171 located in the trenches 41 have about the same width. In addition, the trench 42 has the upper portion 162b adjacent to the second portion 172, and so the width of the second portion 172 is smaller than the width of the first portion(s) 171. In some embodiments, the electrode material layer 17 covering the entire semiconductor material layer 12 may be formed by electroplating or CVD, and then an etching process may be performed to remove the electrode material layer 17 outside the trenches 41 and 42 to form the first portion 171 and the second portion 172. In some embodiments, the electrode material layer 17 includes metal. In some embodiments, the upper surface of the first portion(s) 171 may be flush with the upper surface of the second portion 172. In some embodiments, the first portion(s) 171 and the second portion 172 may be called gate electrodes. For the convenience of description, the dielectric layer 20 located in the trench(es) 41, the first portion 161 of the electrode material layer 16, and the first portion 171 of the electrode material layer 17 will be collectively referred to as a trench structure 50. The dielectric layer 20 in the trench 42, the second portion 162 of the electrode material layer 16, and the second portion 172 of the electrode material layer 17 will be collectively referred to as a trench structure 60. The dielectric layer 20 in the trench 43, and the fourth portion 165 of the electrode material layer 16 will be collectively referred to as a trench structure 70. In addition, the trench structure 50 may be used as an electrode of the semiconductor power device, and thus the trench structure 50 may also be referred to as an electrode structure 50.

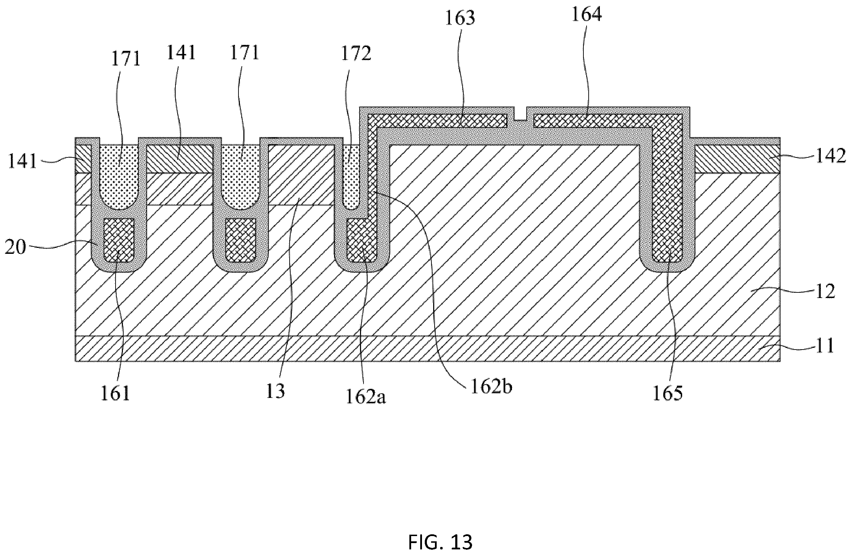

Referring to FIG. 13, the manufacturing method includes forming the body doped region 13 in the semiconductor material layer 12 of the unit region R1. The body doped region 13 may be a second-type doped region formed through a diffusion or ion implantation process from the surface 12A. The depth of the body doped region 13 is less than the depth of the trench structure 50, 60 or 70. In other words, the bottom of the body doped region 13 is higher than the bottom of the trench structure 50, 60 or 70. In addition, since the body doped region 13 offsets the conductivity of the lightly doped region 25, electrically, the coverage of the lightly conductive region 25 may be defined as a part of the semiconductor material layer 12 outside the body doped region 13. In some embodiments, after the ion implantation process is performed to form the body doped region 13, an annealing process may be performed to diffuse the doping ions.

Referring also to FIG. 13, the manufacturing method includes forming the source doped region 141 on the body doped region 13 in the semiconductor material layer 12 of the unit region R1, and forming the doped region 142 in the semiconductor material layer 12 of the terminal region R2 adjacent to the trench structure 70. The source doped region 141 and the doped region 142 may be first-type doped regions formed by a diffusion or ion implantation process from the surface 12A. The doping concentrations of the source doped region 141 and the doped region 142 are approximately the same. The doping concentration of the source doped region 141 may be greater than that of the body doped region 13. The depth of the source doped region 141 may be less than the depth of the body doped region 13. The source doped region 141 may be distributed between adjacent trench structures 50. In some embodiments, the source doped region 141 may also be formed on the body doped region 13 between the trench structure 50 and the trench structure 60 (not shown in the figure). In some embodiments, due to the positions between the trench structure 50 and the trench structure 60 is too close to the high voltage area of the terminal region R2, the source doped region 141 may not be formed between the trench structure 50 and the trench structure 60 in order to ensure the safety and stability of the products. In some embodiments, the doped region 142 may be distributed on the exposed semiconductor material layer 12 in the terminal region R2. In some embodiments, after the ion implantation process is performed to form the source doped region 141 and the doped region 142, an annealing process may be performed to diffuse the doping ions.

In some embodiments, before performing the ion implantation process for the source doped region 141 and the doped region 142, an etching process may be performed to the dielectric layer 20, to reduce the thickness of the planar portion of the dielectric layer 20 above the surface 12A, as shown in FIG. 13. The reduction in thickness of the planar portion of the dielectric layer 20 above the surface 12A facilitates performing the ion implantation process. In some embodiments, the thickness of the planar portion of the dielectric layer 20 above the surface 12A is greater than zero. In other words, the dielectric layer 20 at least covers the surface 12A of the semiconductor material layer 12 to protect the semiconductor material layer 12, in order to reduce the damage to the surface 12A caused by the ion implantation process, and reduce the channel effect as well.

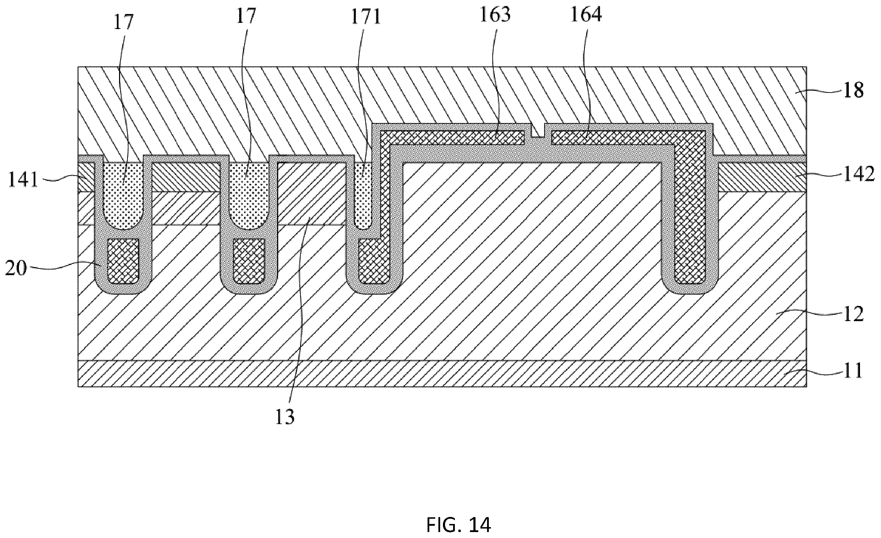

Referring to FIG. 14, the manufacturing method includes forming the interlayer dielectric layer 18 on the surface 12A of the semiconductor material layer 12. The interlayer dielectric layer 18 may be formed by ALD, CVD or other deposition processes.

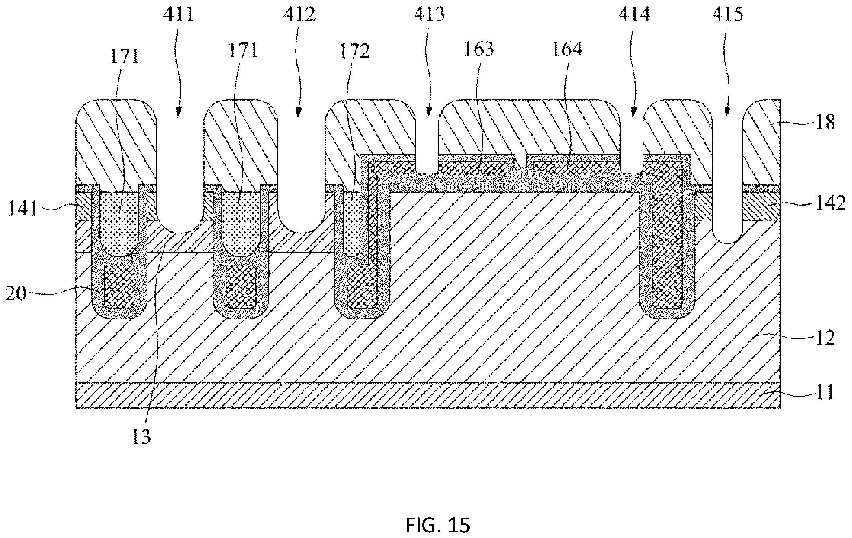

Referring to FIG. 15, the manufacturing method includes partially removing the interlayer dielectric layer 18, and partially removing the semiconductor material layer 12 and the capacitive electrodes 163, 164 by using the upper and lower dielectric layers 18 as masks, to form openings 411, 412, 413, 414, 415. The opening 411 is located between adjacent trench structures 50 and passes through the source doped region 141. The opening 412 is located between the trench structures 50 and 60, and ends in the body doped region 13. The openings 411 and 412 are located in the unit region R1, and may have approximately the same width and approximately the same depth. The openings 413 and 414 are located on the electrode structure in the terminal region R2, and expose, respectively, parts of the capacitive electrodes 163, 164. In some embodiments, the openings 413 and 414 pass through the capacitive electrodes 163 and 164, respectively. The opening 415 is located in the terminal region R2, extending through the doped region 142. The opening 415 may have approximately the same depth as the opening 411 or 412. The width of the opening 414 may be different from the width of the opening 411 or 412. In some embodiments, the width of the opening 414 is smaller than the width of opening 411 or 412.

The openings 411, 412, 413, 414, 415 may be formed through one or more etching processes. For example, a fourth etching process may be performed to partially remove the interlayer dielectric layer 18, and then a fifth etching process may be performed to partially remove an exposed portion of the semiconductor material layer 12 and exposed portions of the capacitive electrodes 163 and 164. In some embodiments, the fourth etching process stops at the surface 12A of the semiconductive material layer 12 or the surfaces of the capacitive electrodes 163 and 164. In some embodiments, the fifth etching process may be performed to etch the semiconductor material layer 12 and the capacitive electrodes 163 and 164 using the dielectric layer 18 as a mask. In some embodiments, since the thickness of the capacitive electrodes 163 and 164 is less than a predetermined depth of the openings 411 and 412, the capacitive electrodes 163 and 164 are penetrated through. In some embodiments, the fifth etch process stops at the upper surface of the dielectric layer 20 that is below the capacitive electrodes 163, 164.

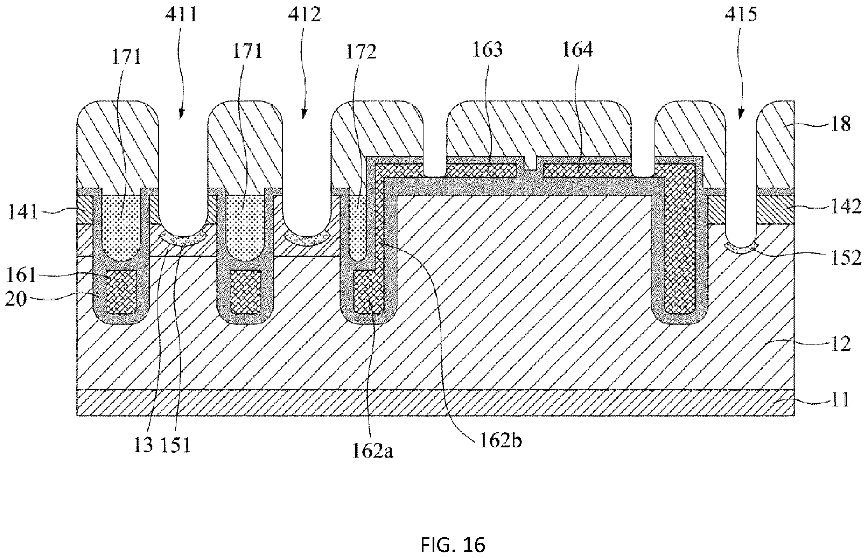

Referring to FIG. 16, the manufacturing method includes performing an ion implantation process to the semiconductor material layer 12 according to the openings 411, 412, 415, to form the heavily doped region(s) 151 in the unit region R1, and the heavily doped region 152 in the terminal region R2. Ions may be implanted in the vertical direction into the semiconductor material layer 12 at the bottom of the openings 411, 412, 415. The heavily doped regions 151 and 152 are respectively formed in the semiconductor material layer 12 close to the bottom of the openings 411, 412, 415. In some embodiments, an annealing process may be performed after the ion implantation process, to form the heavily doped regions 151 and 152 as shown in FIG. 16.

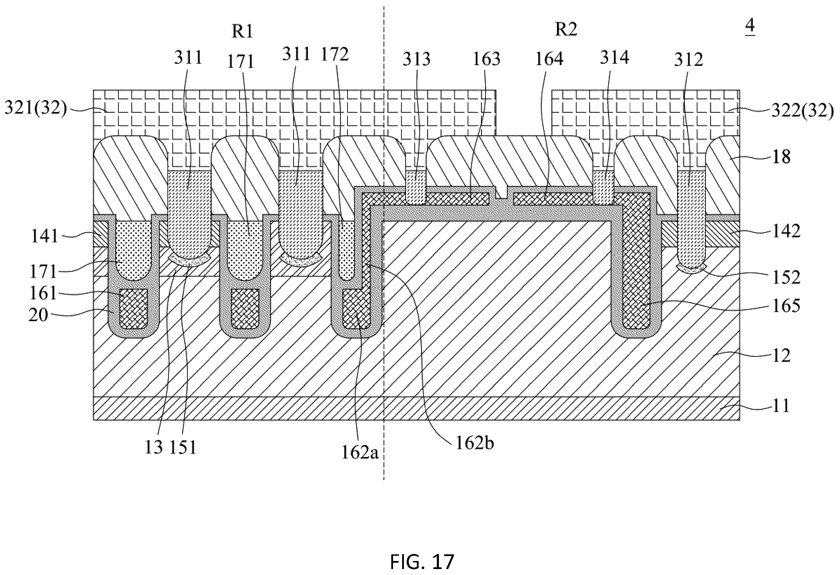

Referring to FIG. 17, the manufacturing method includes forming the conductive plugs 31 in the openings 411, 412, 413, 414, and 415. The conductive plugs 31 may be formed by filling the openings 411, 412, 413, 414, and 415 with conductive material through electroplating or CVD. The material of the conductive plugs 31 may include gold (Au), silver (Ag), copper (Cu), platinum (Pt), palladium (Pd), tungsten (W), titanium (Ti), tantalum (Ta), molybdenum (Mo) or other metals or alloys. In some embodiments, the electroplating or CVD may be followed by an optional planarization process. Therefore, in some embodiments, the upper surfaces of the plurality of conductive plugs 31 may be flush, or located at approximately the same horizontal level.

The configurations/shapes of the conductive plugs 31 are defined by the configurations/shapes of the openings 411, 412, 413, 414, 415, and therefore the conductive plugs 31 have the same configurations/shapes as the openings 411, 412, 413, 414, and 415. The conductive plugs 31 include a plurality of conductive plugs 311 that are in contact with the semiconductor material layer 12 in the unit region R1, and include at least one conductive plug 312 in contact with the semiconductor material layer 12 in the terminal region R2, include at least one conductive plug 313 in contact with the capacitive electrode 163, and include at least one conductive plug 314 in contact with the capacitive electrode 164.

Referring also to FIG. 17, the manufacturing method includes forming a metal layer 32 on the interlayer dielectric layer 18. The metal layer 32 may be formed through electroplating or CVD, and may be patterned according to electrical properties and operating requirements. The material of the metal layer 32 may include copper (Cu), gold (Au), silver (Ag), aluminum (Al), nickel (Ni), titanium (Ti), tungsten (W), tin (Sn) or other metals or alloys. In some embodiments, an etching process may be used to define the metal layer 32 as a plurality of metal wires. In some embodiments, the metal layer 32 includes a metal wire 321 electrically connected to the conductive plugs 311 and 313. In some embodiments, the metal layer 32 includes a metal wire 322 electrically connected to the conductive plugs 312 and 314.

Since the source doped region 141 is not formed between the trench structures 50 and 60, the trench structure 60 may be referred to as a void electrode structure. In other embodiments described previously, the source doped region 141 may be formed in the semiconductor material layer 12 between the trench structures 50 and 60. In these embodiments, due to the existence of the source doped region 141, the trench structure 60 can operate as a normal electrode structure, and so the trench structure 60 may be called an electrode structure. The second portion 172 of the electrode material layer 17 may also be called a gate electrode.

A vertical power semiconductor device 4 formed through the above steps as shown in FIG. 17 may be the same as the vertical power semiconductor device 1 shown in FIG. 1. The vertical power semiconductor device 4 includes the capacitor structure (including the capacitive electrodes 163 and 164), well integrates the process of the RC snubber with the process of general vertical power semiconductor devices (or a preceding process of semiconductor manufacturing), provides stable resistance and capacitance values, and achieve the effect of saving the process cost and reducing the total surface area of the device while providing good damping.

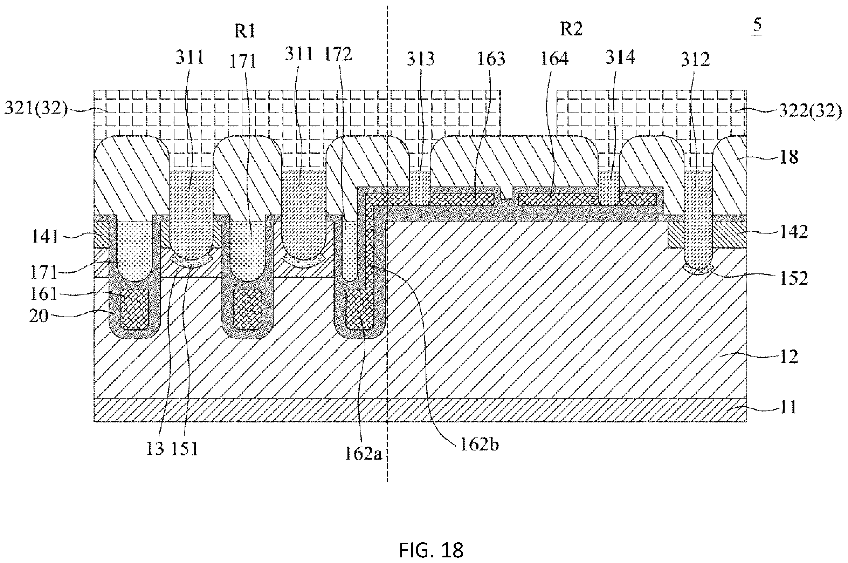

According to the structures and processes of the embodiments of the present disclosure described above, and with the same purpose and concept, the steps in the above processes may be adjusted or the order of the steps may be changed, in order to result in the same or similar vertical power semiconductor devices. FIG. 18 to FIG. 24 illustrate another example of one or more stages in a manufacturing method of a vertical power semiconductor device according to other embodiments of the present disclosure. At least some of the figures have been simplified in order for better understanding aspects of the present disclosure. To simplify the description, the following will only describe the differences compared with the processes as described with respect to FIG. 4 to FIG. 17, and the same or similar steps will not be repeatedly described.

Referring to FIG. 18, a vertical power semiconductor device 5 may be formed by following the steps from FIG. 4 to FIG. 17 as described previously. A difference is that, in the embodiment of FIG. 18, the trench 43 is not formed in the step of FIG. 4. The vertical power semiconductor device 5 as shown in FIG. 18 is formed according to the steps as described with respect to FIG. 5 to FIG. 17. A difference between the vertical power semiconductor device 5 and the vertical power semiconductor devices 4 as shown in FIG. 17 is that the vertical power semiconductor device 5 does not have the trench structure 70 included in the vertical power semiconductor device 4. Under a condition including the same size, operating voltage, and so on, the vertical power semiconductor devices 4 may have better EQR effect than the vertical power semiconductor device 5.

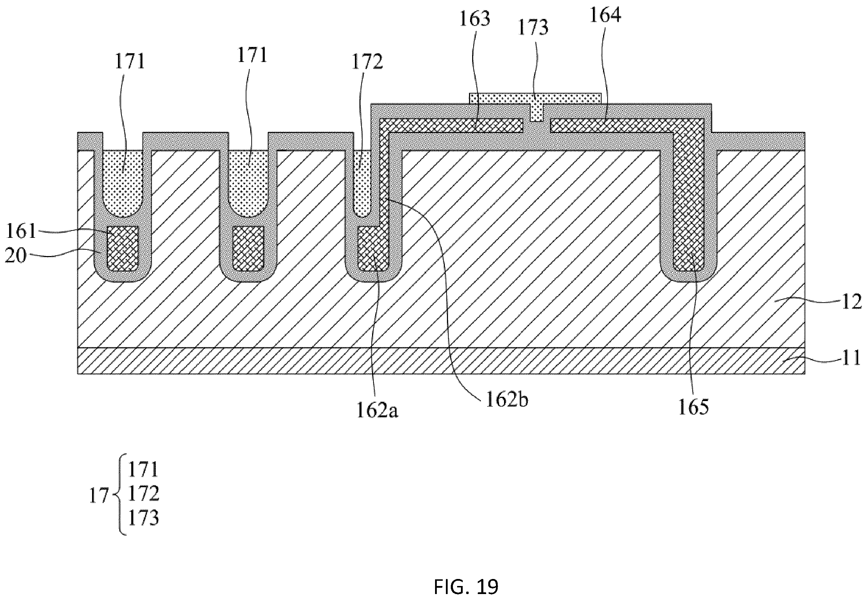

Referring to FIG. 19, steps from FIG. 4 to FIG. 12 are performed, and in the step of forming the electrode material layer 17 as described with respect to FIG. 12, the electrode material layer 17 including different portions may be formed according to the patterned photomasks used. As shown in FIG. 19, the electrode material layer 17 may also include a third portion 173 located above the capacitive structure. In some embodiments, the third portion 173 may be formed in the same step as the first portion 171 and the second portion 172. The third portion 173 of the electrode material layer 17 is disposed above the capacitor structure, and overlaps with at least one of the capacitive electrode 163 or the capacitive electrode 164. In other words, the third portion 173 covers part of the capacitive electrode 163 and/or part of the capacitive electrode 164. The third portion 173 is used to increase the capacitance value of the capacitor structure, without increasing the total surface area and total process cost of the device. In some embodiments, the third portion 173 may cover part of the capacitive electrode 163 and part of the capacitive electrode 164. In some embodiments, the third portion 173 may also be disposed between the capacitive electrode 163 and the capacitive electrode 164.

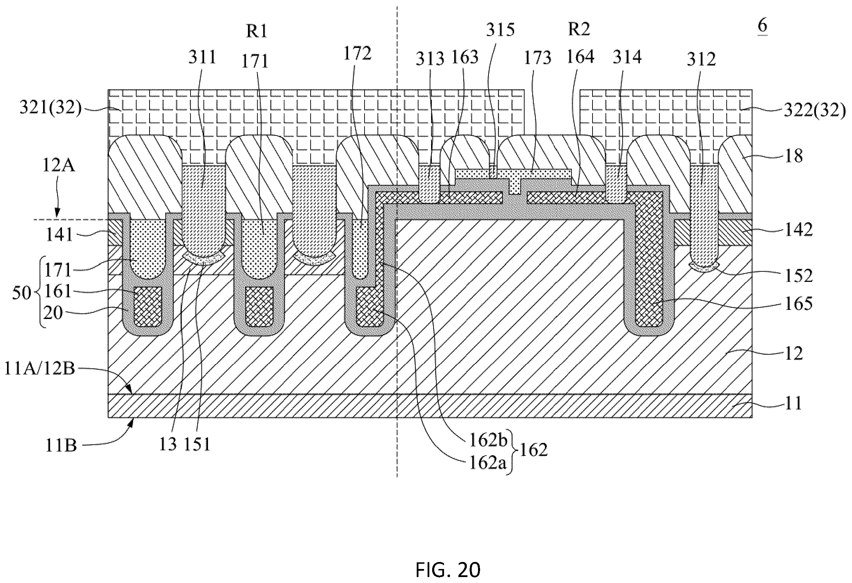

Referring to FIG. 20, a vertical power semiconductor device 6 may be formed by following the steps from FIG. 13 to FIG. 17 after the step of FIG. 19 is performed. Since the vertical power semiconductor device 6 includes the third portion 173, which is additional compared with the vertical power semiconductor device 4, one more opening needs to be formed in the step of FIG. 15 to expose the third portion 173. In some embodiments, the above-mentioned opening may pass through the third portion 173. In addition, in the step of FIG. 17, a conductive plug 315 may be formed in the above-mentioned opening to electrically connect to the third portion 173. In some embodiments, the conductive plug 315 may be electrically connected to the conductive plugs 311 and 313 via the metal wire 321. In some embodiments, the conductive plug 315 is flush with, or is approximately at the same horizontal level as, the upper surfaces of the other conductive plugs 311, 312, 313, 314. In some embodiments, after the step of forming the third portion 173, the etching process as described with respect to FIG. 13 to reduce the thickness of the planar portion of the dielectric layer 20 on the surface 12A may be performed to the dielectric layer 20. In some embodiments, the portion of the dielectric layer 20 covered by the third portion 173 has a thickness greater than that of other planar portions of the dielectric layer 20 on the surface 12A. The method shown in FIG. 19 to FIG. 20 is not part of the claimed invention, and the structure resulting from the method is a device according to the claimed invention of this application.

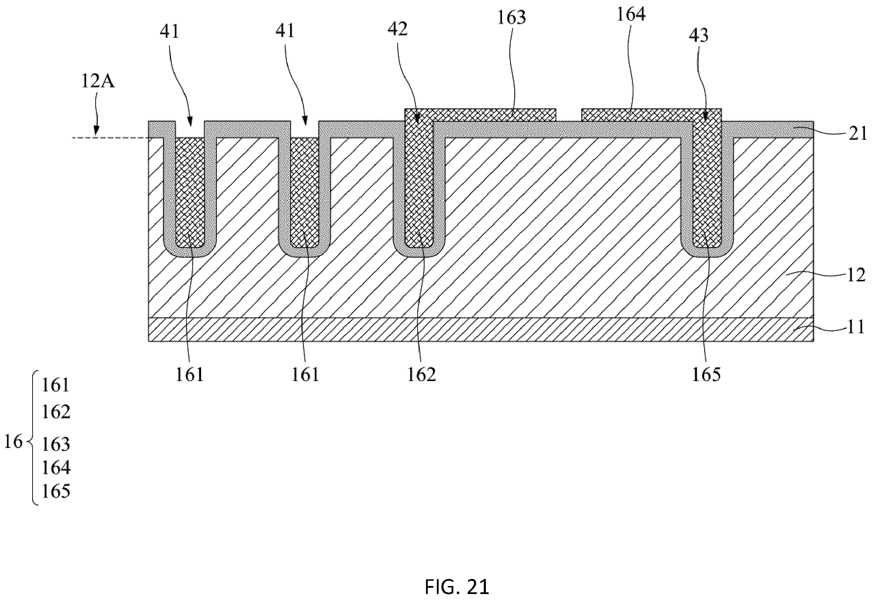

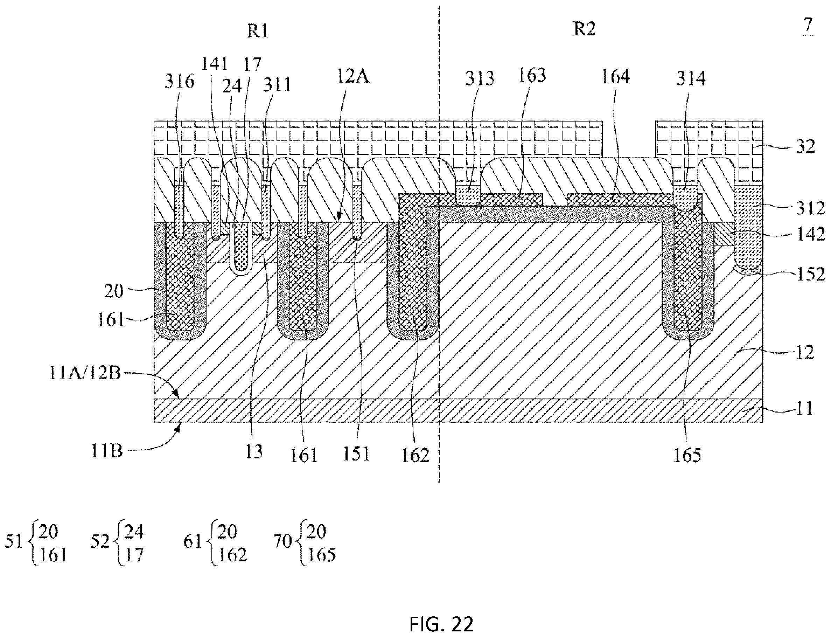

Referring to FIGs. 21 and 22, a vertical power semiconductor device 7, which does not form part of the claimed invention, may be formed by following the steps and technical concepts of FIG. 4 to FIG. 17 described above, with integration of the process of dual-trench semiconductor power devices. The vertical power semiconductor device 7 includes a plurality of shield electrode structures 51 in the unit region R1, a trench structure 61 located in the unit region R1 and adjoining the terminal region R2, a gate electrode structure 52 between adjacent shield electrode structures 51 in the unit region R1, and a trench structure 70 located in the terminal region R2. The trench structure 70 of the vertical power semiconductor device 7 is similar to the trench structure 70 of the vertical power semiconductor device 4, and will not be described repeatedly.

The shield electrode structures 51 and the trench structure 61 may be formed following the steps described with respect to FIG. 4 to FIG. 7. In some embodiments, the shield electrode structures 51 and the trench structure 61 have approximately the same depth. In some embodiments, the first portion 161 of the conductive material layer 16 of the shield electrode structures 51 and the second portion 162 of the conductive material layer 16 of the trench structure 61 extend from the surface 12A toward the surface 12B, and the first portion 161 and the second portion 162 have approximately the same depth. In some embodiments, the first portion 161 and the second portion 162 have approximately the same width at the surface 12A. It should be noted that in order to form the shield electrode structures 51 and the trench structure 61 as shown in FIG. 22, the etching process in the steps of FIG. 7 needs to be adjusted accordingly. Following the steps of FIG. 7, the electrode capacitors 163 and 164 may be formed together with the electrode material layers 161, 162 of the shield electrode structures 51 and the trench structure 61. In some embodiments, the electrode capacitors 163, 164, and the first portion 161, the second portion 162 and the fourth portion 165 of the electrode material layer 16 may be defined by the same photomask, as shown in FIG. 21. In some embodiments, after the step of FIG. 21 is performed and before the step of forming the electrode material layer 17 in FIG. 12 is performed, a portion of the semiconductor material layer 12 may be removed to form a trench having a depth smaller than that of the shield electrode structures 51 and located between the adjacent shield electrode structures 51, to define the position of the gate electrode structure 52. After a dielectric layer 24 is formed underlying the trench, the aforementioned steps of forming the electrode material layer 17 are performed, to form the electrode material layer 17 in the above-mentioned trench, where the electrode material layer 17 is surrounded by the dielectric layer 24. Then, the vertical power semiconductor device 7 is formed by following/using the steps described with respect to FIG. 14 to FIG. 17. The vertical power semiconductor device 7 also includes conductive plug(s) 316 contacting the electrode material layer 161 of the shield electrode structures 51. In some embodiments, the conductive plug(s) 316 are flush with the upper surfaces of the other conductive plugs 311, 312, 313, 314, or are located at approximately the same horizontal level.

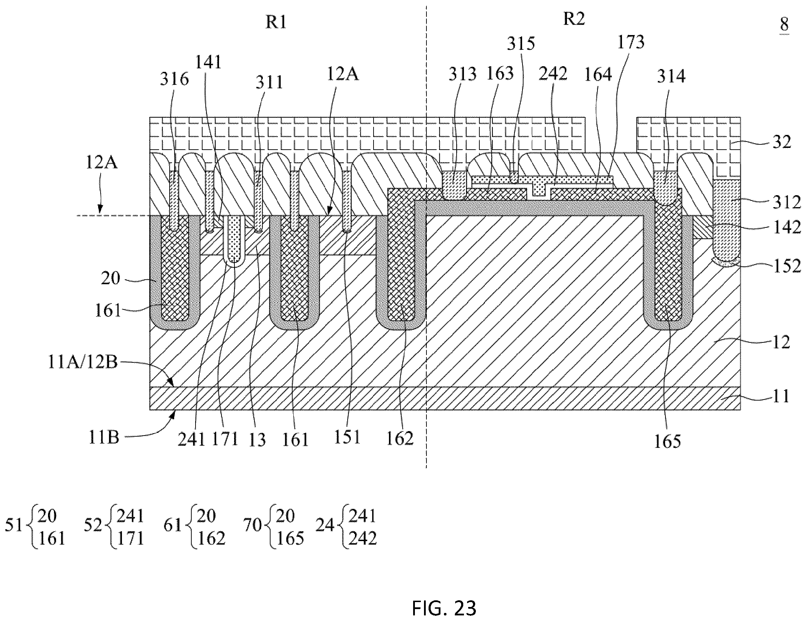

Referring to FIG. 23, a vertical power semiconductor device 8, which does not form part of the claimed invention, is similar to the vertical power semiconductor device 7, and further includes the third portion 173 of the electrode material layer 17 similar to that of the vertical power semiconductor device 6. Due to the structure difference between a double trench semiconductor power device and a split-gate vertical power semiconductor device, the steps of FIGs. 10 and 11 are not needed for the vertical power semiconductor device 8. In other words, for the vertical power semiconductor device 8, the dielectric layer layers 22 and 23 will not be formed before the electrode material layer 17 is formed. In some embodiments, while forming the dielectric layer 24 of the gate electrode structure 52 in FIG. 22, a portion of the dielectric layer 24 on the capacitive electrodes 163, 164 may be retained by using a photomask to define the pattern of the dielectric layer 24. As shown in FIG. 23, the dielectric layer 24 includes a first portion 241 of the gate electrode structure 52 located in the unit region R1, and a second portion 242 on the capacitive electrodes 163, 164 in the terminal region R2. The third portion 173 of the electrode material layer 17 is separated from the capacitive electrodes 163, 164 by the second portion 242 of the dielectric layer 24. In some embodiments, the third portion 173 of the electrode material layer 17 overlaps at least one of the capacitive electrode 163 or the capacitive electrode 164.

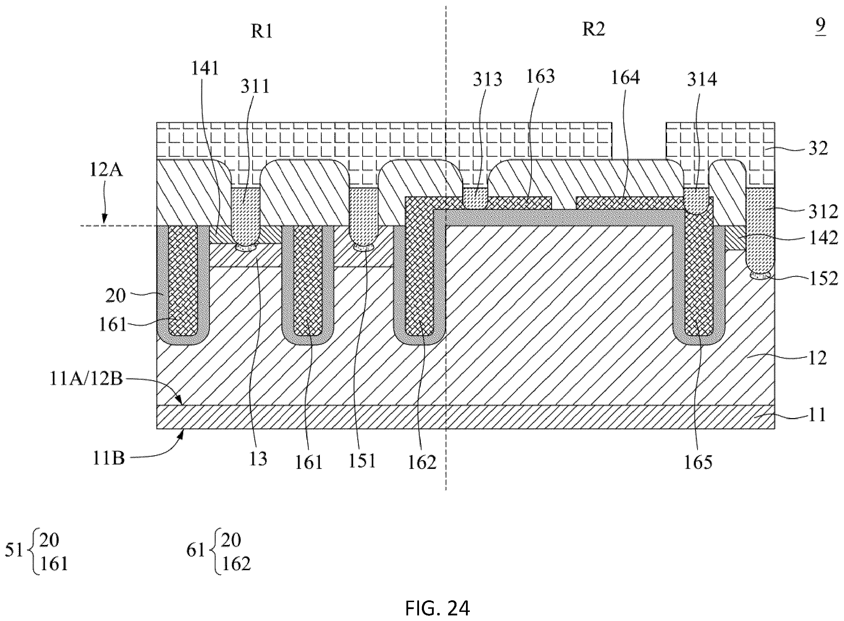

Referring to FIG. 24, a vertical power semiconductor device 9, which does not form part of the claimed invention, is a single-trench semiconductor power device, and has a similar structure to that of the vertical power semiconductor device 7, except that the vertical power semiconductor device 9 lacks the electrode structure 52 of the vertical power semiconductor device 7 (since there is no distinction between a gate electrode structure and a shield electrode structure for single-trench semiconductor power devices, the gate electrode structure and the shield electrode structure are generally referred to as an electrode structure when describing the single-trench semiconductor power devices). Similar to the vertical power semiconductor devices 7, 8, the capacitive electrodes 163, 164 can be formed together with the electrode material layer 161 of the electrode structure 51 in the same step. Those of ordinary skill in the art would understand the differences between the single-trench semiconductor power devices and the dual-trench semiconductor power devices, and the other components may be adjusted accordingly according to the needs.

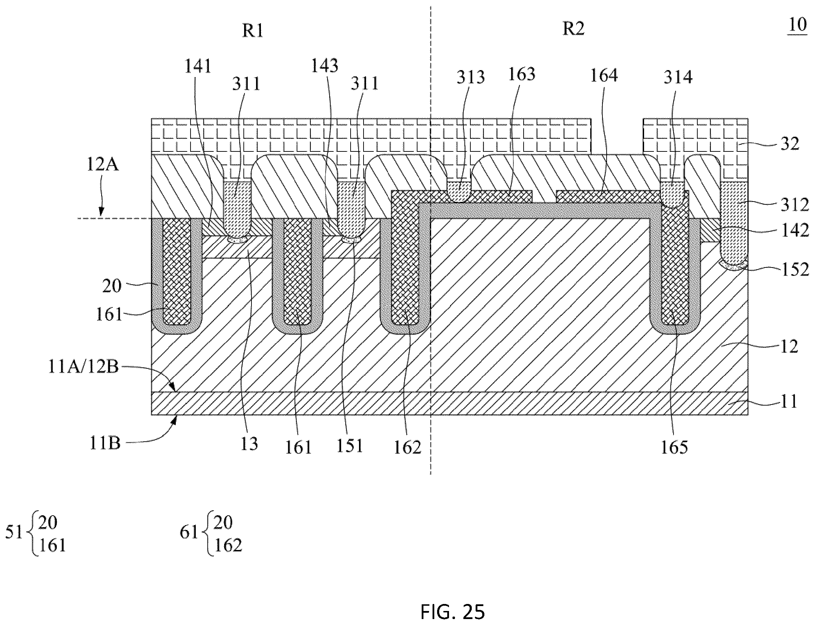

Referring to FIG. 25, a vertical power semiconductor device 10, which does not form part of the claimed invention, is similar to the vertical power semiconductor device 9, with the difference that there is a source doped region 143 between the conductive plug 311 adjacent to the trench structure 61 and the trench structure 51 adjacent to the conductive plug 311. As described above, the trench structure 61 and the trench structure 51 may be provided with source doped regions according to requirements or specifications. In some embodiments, in order to form a functional semiconductor power structure to the maximum extent, the source doped region 143 may be formed between the conductive plug 311 close to the trench structure 61 and an adjacent trench structure 51 (a trench structure 51 adjacent to the conductive plug 311). Because no source doped region is formed between the trench structure 61 and its adjacent conductive plug 311, the stability and safety of the vertical power semiconductor device 10 can be ensured. The source doped region 143 as shown in FIG. 25 can be applied to the vertical power semiconductor devices 1, 4, 5, 6, 7, 8, and 9, which is not limited hereto. In addition, the third portion 173 of the conductive material layer 17 in FIGs. 20 and 23 can also be applied to the embodiments of FIGs. 24 and 25, which is not limited hereto.

In this disclosure, for the description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or at other orientations), and the spatially relative terms used herein may be interpreted in a corresponding way similarly. It should be understood that when a component is referred to as being "connected" or "coupled" to another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to the occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values.

The foregoing has outlined features of some embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. Although the description has been described in detail, it should be understood that various changes, substitutions and alterations can be made without departing from the scope of this invention as defined by the appended claims.

## Claims

1. A semiconductor structure (1), comprising:
a substrate (12), comprising a first surface (12A) and a second surface (12B) opposite to each other, and comprising a unit region (R1) and a terminal region (R2) adjacent to each other in a top view of the substrate (12);
a first electrode structure (50) in the substrate (12) and extending from the first surface (12A) toward the second surface (12B), the first electrode structure (50) being disposed in the unit region;
a first trench structure (60) in the substrate (12) and extending from the first surface (12A) toward the second surface (12B), the first trench structure (60) being disposed in the unit region and adjoining the terminal region (R2), and the first trench structure (60) comprising a first semiconductor material layer (162) extending to the first surface (12A); and
a capacitive structure on the first surface (12A) of the substrate (12), the capacitive structure being disposed in the terminal region (R2) and adjoining the first trench structure (60), wherein the capacitive structure has a material same as the first semiconductor material layer (162), the capacitive structure includes a first capacitive electrode (163) and a second capacitive electrode (164), and the first capacitive electrode (163) is connected to the first semiconductor material layer (162),
wherein: the first electrode structure (50) comprises a first gate electrode layer (171) and a first shield electrode layer (161) below the first gate electrode layer (171),
the first trench structure (60) comprises a second gate electrode layer (172) adjacent to the first semiconductor material layer (162),
a width of the first gate electrode layer (171) is greater than a width of the second gate electrode layer (172),
a bottom of the first gate electrode layer (171) and a bottom of the second gate electrode layer (172) are at a same horizontal level,
a first portion (162a) of the first semiconductor material layer (162) is below the second gate electrode layer (172), and a second portion (162b) of the first semiconductor material layer (162) is connected to the first portion (162a) and disposed at a side of the second gate electrode layer (172), and
a width of the first portion (162a) of the first semiconductor material layer (162) and a width of the first shield electrode layer (161) are substantially equal, and the width of the first portion (162a) of the first semiconductor material layer (162) is greater than a width of the second portion (162b) of the first semiconductor material layer (162), wherein the widths of the first (171) and second (172) gate electrode layers, the width of the first portion (162a), the width of the first shield electrode layer (161), and the width of the second portion (162b) are defined in a direction from the first electrode structure (50) toward the first trench structure (60).

2. The semiconductor structure of claim 1, further comprising:
a second trench structure (70) in the substrate (12) and extending from the first surface (12A) toward the second surface (12B), the second trench structure (70) being disposed in the terminal region (R2) and comprising a second semiconductor material layer (165) that extends to the first surface (12A), and the second capacitive electrode (164) being connected to the second semiconductor material layer (165).

3. The semiconductor structure of claim 1 or 2, wherein a bottom of the first electrode structure (50) and a bottom of the first trench structure (60) are at a same horizontal level.

4. The semiconductor structure of claim 1, wherein,
the first portion (162a) comprises a first sidewall (601) and a second sidewall (602) opposite to each other, the second portion (162b) comprises a third sidewall (603) and a fourth sidewall (604) opposite to each other, and the first sidewall (601) and the third sidewall are continuous sidewalls, and the fourth sidewall (604) ends on an upper surface (605) of the first portion (162a), and the fourth sidewall (604) and the second sidewall (602) are discontinuous sidewalls; and
the upper surface of the first portion of the first semiconductor material layer (162) connects to the second portion of the first semiconductor material layer (162), and the upper surface of the first portion of the first semiconductor material layer (162) and an upper surface of the first shield electrode layer (161) are at a same horizontal level.

5. The semiconductor structure of any preceding claim, wherein,
a top surface of the first capacitive electrode (163) is substantially flush with a top surface of the second capacitive electrode (164), and a bottom surface of the first capacitive electrode (163) on the first surface (12A) is substantially flush with a bottom surface of the second capacitive electrode (164) on the first surface (12A); or
a thickness of the first capacitive electrode (163) on the first surface (12A) is substantially equal to a thickness of the second capacitive electrode (164) on the first surface (12A).

6. The semiconductor structure of any preceding claim, further comprising:
a conductive material layer (173) above the capacitive structure, the conductive material layer overlapping at least one of the first capacitive electrode (163) and the second capacitive electrode (164), wherein the first capacitive electrode (163) and the second capacitive electrode (164) comprise a semiconductor material including metal.

7. The semiconductor structure of any preceding claim, further comprising:
a first conductive plug (313) on the first capacitive electrode (163), the first conductive plug (313) electrically connected to the first capacitive electrode (163);
a second conductive plug (314) on the second capacitive electrode (164), the second conductive plug (314) electrically connected to the second capacitive electrode (164);
a third conductive plug (311) extending from above the first surface (12A) toward the second surface (12B), the third conductive plug (311) disposed in the unit region and adjacent to the first electrode structure (50), and a top surface of the third conductive plug (311) and a top surface of the first conductive plug (313) or the second conductive plug (314) being at a same horizontal level; and
a fourth conductive plug (312) extending from above the first surface (12A) toward the second surface (12B), the fourth conductive plug (312) disposed in the terminal region (R2) and adjacent to the second capacitive electrode (164), and the second capacitive electrode (164) being electrically connected to the fourth conductive plug (312) through a metal wire layer (322) provided above the second conductive plug (314) and the fourth conductive plug (312).

## Patentansprüche

1. Halbleiterstruktur (1), umfassend:
ein Substrat (12), umfassend eine erste Oberfläche (12A) und eine zweite Oberfläche (12B), welche einander gegenüberliegen, und umfassend einen Einheitsbereich (R1) und einen Anschlussbereich (R2), welche in einer Draufsicht des Substrats (12) aneinandergrenzen;
eine erste Elektrodenstruktur (50) in dem Substrat (12), welche sich von der ersten Oberfläche (12A) zu der zweiten Oberfläche (12B) hin erstreckt, wobei die erste Elektrodenstruktur (50) in dem Einheitsbereich angeordnet ist;
eine erste Grabenstruktur (60) in dem Substrat (12), welche sich von der ersten Oberfläche (12A) zu der zweiten Oberfläche (12B) hin erstreckt, wobei die erste Grabenstruktur (60) in dem Einheitsbereich angeordnet ist und an den Anschlussbereich (R2) angrenzt, und die erste Grabenstruktur (60) eine erste Halbleitermaterialschicht (162) umfasst, welche sich bis zu der ersten Oberfläche (12A) erstreckt; und
eine kapazitive Struktur auf der ersten Oberfläche (12A) des Substrats (12), wobei die kapazitive Struktur in dem Anschlussbereich (R2) angeordnet ist und an die erste Grabenstruktur (60) angrenzt, wobei die kapazitive Struktur ein gleiches Material wie die erste Halbleitermaterialschicht (162) aufweist, die kapazitive Struktur eine erste kapazitive Elektrode (163) und eine zweite kapazitive Elektrode (164) beinhaltet, und die erste kapazitive Elektrode (163) mit der ersten Halbleitermaterialschicht (162) verbunden ist.
wobei die erste Elektrodenstruktur (50) eine erste Gate-Elektrodenschicht (171) und eine erste Schirmelektrodenschicht (161) unterhalb der ersten Gate-Elektrodenschicht (171) umfasst,
die erste Grabenstruktur (60) eine zweite Gate-Elektrodenschicht (172) umfasst, welche an die erste Halbleitermaterialschicht (162) angrenzt,
eine Breite der ersten Gate-Elektrodenschicht (171) größer als eine Breite der zweiten Gate-Elektrodenschicht (172) ist,
eine Unterseite der ersten Gate-Elektrodenschicht (171) und eine Unterseite der zweiten Gate-Elektrodenschicht (172) sich auf derselben horizontalen Ebene befinden,
ein erster Abschnitt (162a) der ersten Halbleitermaterialschicht (162) sich unterhalb der zweiten Gate-Elektrodenschicht (172) befindet, und ein zweiter Abschnitt (162b) der ersten Halbleitermaterialschicht (162) mit dem ersten Abschnitt (162a) verbunden und an einer Seite der zweiten Gate-Elektrodenschicht (172) angeordnet ist, und
eine Breite des ersten Abschnitts (162a) der ersten Halbleitermaterialschicht (162) und eine Breite der ersten Schirmelektrodenschicht (161) im Wesentlichen gleich sind, und die Breite des ersten Abschnitts (162a) der ersten Halbleitermaterialschicht (162) größer ist als eine Breite des zweiten Abschnitts (162b) der ersten Halbleitermaterialschicht (162), wobei die Breite der ersten (171) und zweiten (172) Gate-Elektrodenschicht, die Breite des ersten Abschnitts (162a), die Breite der ersten Schirmelektrodenschicht (161) und die Breite des zweiten Abschnitts (162b) in einer Richtung von der ersten Elektrodenstruktur (50) zu der ersten Grabenstruktur (60) hin definiert sind.

2. Halbleiterstruktur nach Anspruch 1, weiter umfassend:
eine zweite Grabenstruktur (70) in dem Substrat (12), welche sich von der ersten Oberfläche (12A) zu der zweiten Oberfläche (12B) hin erstreckt, wobei die zweite Grabenstruktur (70) in dem Anschlussbereich (R2) angeordnet ist und eine zweite Halbleitermaterialschicht (165) umfasst, welche sich bis zu der ersten Oberfläche (12A) erstreckt; und die zweite kapazitive Elektrode (164) mit der zweiten Halbleitermaterialschicht (165) verbunden ist.

3. Halbleiterstruktur nach Anspruch 1 oder 2, wobei eine Unterseite der ersten Elektrodenstruktur (50) und eine Unterseite der ersten Grabenstruktur (60) sich auf derselben horizontalen Ebene befinden.

4. Halbleiterstruktur nach Anspruch 1, wobei
der erste Abschnitt (162a) eine erste Seitenwand (601) und eine zweite Seitenwand (602) umfasst, welche einander gegenüberliegen, der zweite Abschnitt (162b) eine dritte Seitenwand (603) und eine vierte Seitenwand (604) umfasst, welche einander gegenüberliegen, und die erste Seitenwand (601) und die dritte Seitenwand durchgehende Seitenwände sind, und die vierte Seitenwand (604) an einer oberen Oberfläche (605) des ersten Abschnitts (162a) endet, und die vierte Seitenwand (604) und die zweite Seitenwand (602) unterbrochene Seitenwände sind; und
die obere Oberfläche des ersten Abschnitts der ersten Halbleitermaterialschicht (162) mit dem zweiten Abschnitt der ersten Halbleitermaterialschicht (162) verbunden ist, und die obere Oberfläche des ersten Abschnitts der ersten Halbleitermaterialschicht (162) und eine oberer Oberfläche der ersten Schirmelektrodenschicht (161) sich auf derselben horizontalen Ebene befinden.

5. Halbleiterstruktur nach einem vorstehenden Anspruch, wobei
eine obere Oberfläche der ersten kapazitiven Elektrode (163) im Wesentlichen bündig mit einer oberen Oberfläche der zweiten kapazitiven Elektrode (164) ist, und eine untere Oberfläche der ersten kapazitiven Elektrode (163) auf der ersten Oberfläche (12A) im Wesentlichen bündig mit einer unteren Oberfläche der zweiten kapazitiven Elektrode (164) auf der ersten Oberfläche (12A) ist; oder
eine Dicke der ersten kapazitiven Elektrode (163) auf der ersten Oberfläche (12A) im Wesentlichen gleich einer Dicke der zweiten kapazitiven Elektrode (164) auf der ersten Oberfläche (12A) ist.

6. Halbleiterstruktur nach einem vorstehenden Anspruch, weiter umfassend:
eine leitfähige Materialschicht (173) über der kapazitiven Struktur, wobei die leitfähige Materialschicht zumindest eine von der ersten kapazitiven Elektrode (163) und der zweiten kapazitiven Elektrode (164) überlappt, wobei die erste kapazitive Elektrode (163) und die zweite kapazitive Elektrode (164) ein Halbleitermaterial umfassen, welches Metall beinhaltet.

7. Halbleiterstruktur nach einem vorstehenden Anspruch, weiter umfassend:
einen ersten leitfähigen Stecker (313) auf der ersten kapazitiven Elektrode (163), wobei der erste leitfähige Stecker (313) mit der ersten kapazitiven Elektrode (163) elektrisch verbunden ist;
einen zweiten leitfähigen Stecker (314) auf der zweiten kapazitiven Elektrode (164), wobei der zweite leitfähige Stecker (314) mit der zweiten kapazitiven Elektrode (164) elektrisch verbunden ist;
einen dritten leitfähigen Stecker (311), welcher sich von oberhalb der ersten Oberfläche (12A) zu der zweiten Oberfläche (12B) hin erstreckt, wobei der dritte leitfähige Stecker (311) in dem Einheitsbereich und angrenzend an die erste Elektrodenstruktur (50) angeordnet ist, und eine obere Oberfläche des dritten leitfähigen Steckers (311) und eine obere Oberfläche des ersten leitfähigen Steckers (313) oder des zweiten leitfähigen Steckers (314) sich auf derselben horizontalen Ebene befinden; und
einen vierten leitfähigen Stecker (312), welcher sich von oberhalb der ersten Oberfläche (12A) zu der zweiten Oberfläche (12B) hin erstreckt, wobei der vierte leitfähige Stecker (312) in dem Anschlussbereich (R2) und angrenzend an die zweite kapazitive Elektrode (164) angeordnet ist, und die zweite kapazitive Elektrode (164) über eine Metallisierungsschicht (322), welche oberhalb des zweiten leitfähigen Steckers (314) und des vierten leitfähigen Steckers (312) bereitgestellt ist, mit dem vierten leitfähigen Stecker (312) elektrisch verbunden ist.

## Revendications

1. Structure semi-conductrice (1), comprenant :
un substrat (12), comprenant une première surface (12A) et une deuxième surface (12B) opposées l'une à l'autre, et comprenant une région unitaire (R1) et une région terminale (R2) adjacentes l'une à l'autre selon une vue de dessus du substrat (12) ;
une première structure d'électrode (50) située dans le substrat (12) et s'étendant de la première surface (12A) vers la deuxième surface (12B), la première structure d'électrode (50) étant disposée dans la région unitaire ;
une première structure de tranchée (60) située dans le substrat (12) et s'étendant de la première surface (12A) vers la deuxième surface (12B), la première structure de tranchée (60) étant disposée dans la région unitaire et jouxtant la région terminale (R2), et la première structure de tranchée (60) comprenant une première couche de matériau semi-conducteur (162) s'étendant jusqu'à la première surface (12A) ; et
une structure capacitive située sur la première surface (12A) du substrat (12), la structure capacitive étant disposée dans la région terminale (R2) et jouxtant la première structure de tranchée (60), dans laquelle la structure capacitive présente un matériau identique à celui de la première couche de matériau semi-conducteur (162), la structure capacitive inclut une première électrode capacitive (163) et une deuxième électrode capacitive (164), et la première électrode capacitive (163) est reliée à la première couche de matériau semi-conducteur (162),
dans laquelle la première structure d'électrode (50) comprend une première couche d'électrode de grille (171) et une première couche d'électrode de blindage (161) sous la première couche d'électrode de grille (171),
la première structure de tranchée (60) comprend une deuxième couche d'électrode de grille (172) adjacente à la première couche de matériau semi-conducteur (162),
la largeur de la première couche d'électrode de grille (171) est supérieure à la largeur de la deuxième couche d'électrode de grille (172),
le fond de la première couche d'électrode de grille (171) et le fond de la deuxième couche d'électrode de grille (172) sont au même niveau horizontal,
une première partie (162a) de la première couche de matériau semi-conducteur (162) est située sous la deuxième couche d'électrode de grille (172), et une deuxième partie (162b) de la première couche de matériau semi-conducteur (162) est reliée à la première partie (162a) et disposée sur le côté de la deuxième couche d'électrode de grille (172), et
la largeur de la première partie (162a) de la première couche de matériau semi-conducteur (162) et la largeur de la première couche d'électrode de blindage (161) sont sensiblement égales, et la largeur de la première partie (162a) de la première couche de matériau semi-conducteur (162) est supérieure à la largeur de la deuxième partie (162b) de la première couche de matériau semi-conducteur (162), dans laquelle la largeur des première (171) et deuxième (172) couches d'électrode de grille, la largeur de la première partie (162a), la largeur de la première couche d'électrode de blindage (161) et la largeur de la deuxième partie (162b) sont définies dans une direction allant de la première structure d'électrode (50) vers la première structure de tranchée (60).

2. Structure semi-conductrice selon la revendication 1, comprenant en outre :
une deuxième structure de tranchée (70) située dans le substrat (12) et s'étendant de la première surface (12A) vers la deuxième surface (12B), la deuxième structure de tranchée (70) étant disposée dans la région terminale (R2) et comprenant une deuxième couche de matériau semi-conducteur (165) qui s'étend jusqu'à la première surface (12A), et la deuxième électrode capacitive (164) étant reliée à la deuxième couche de matériau semi-conducteur (165).

3. Structure semi-conductrice selon la revendication 1 ou 2, dans laquelle le fond de la première structure d'électrode (50) et le fond de la première structure de tranchée (60) sont au même niveau horizontal.

4. Structure semi-conductrice selon la revendication 1, dans laquelle :
la première partie (162a) comprend une première paroi latérale (601) et une deuxième paroi latérale (602) opposées l'une à l'autre, la deuxième partie (162b) comprend une troisième paroi latérale (603) et une quatrième paroi latérale (604) opposées l'une à l'autre, et la première paroi latérale (601) et la troisième paroi latérale sont des parois latérales continues, et la quatrième paroi latérale (604) se termine sur une surface supérieure (605) de la première partie (162a), et la quatrième paroi latérale (604) et la deuxième paroi latérale (602) sont des parois latérales discontinues ; et
la surface supérieure de la première partie de la première couche de matériau semi-conducteur (162) se relie à la deuxième partie de la première couche de matériau semi-conducteur (162), et la surface supérieure de la première partie de la première couche de matériau semi-conducteur (162) et la surface supérieure de la première couche d'électrode de blindage (161) sont au même niveau horizontal.

5. Structure semi-conductrice selon une quelconque revendication précédente, dans laquelle :
une surface supérieure de la première électrode capacitive (163) est sensiblement affleurant avec une surface supérieure de la deuxième électrode capacitive (164), et une surface inférieure de la première électrode capacitive (163) sur la première surface (12A) est sensiblement affleurant avec une surface inférieure de la deuxième électrode capacitive (164) sur la première surface (12A) ; ou
l'épaisseur de la première électrode capacitive (163) située sur la première surface (12A) est sensiblement égale à l'épaisseur de la deuxième électrode capacitive (164) située sur la première surface (12A).

6. Structure semi-conductrice selon une quelconque revendication précédente, comprenant en outre :
une couche de matériau conducteur (173) située au-dessus de la structure capacitive, la couche de matériau conducteur chevauchant au moins l'une de la première électrode capacitive (163) et la deuxième électrode capacitive (164), dans laquelle la première électrode capacitive (163) et la deuxième électrode capacitive (164) comprennent un matériau semi-conducteur incluant du métal.

7. Structure semi-conductrice selon une quelconque revendication précédente, comprenant en outre :
une première fiche conductrice (313) située sur la première électrode capacitive (163), la première fiche conductrice (313) étant reliée électriquement à la première électrode capacitive (163) ;
une deuxième fiche conductrice (314) située sur la deuxième électrode capacitive (164), la deuxième fiche conductrice (314) étant reliée électriquement à la deuxième électrode capacitive (164) ;
une troisième fiche conductrice (311) s'étendant depuis au-dessus de la première surface (12A) vers la deuxième surface (12B), la troisième fiche conductrice (311) étant disposée dans la région unitaire et adjacente à la première structure d'électrode (50), et la surface supérieure de la troisième fiche conductrice (311) et la surface supérieure de la première fiche conductrice (313) ou de la deuxième fiche conductrice (314) étant au même niveau horizontal ; et
une quatrième fiche conductrice (312) s'étendant depuis au-dessus de la première surface (12A) vers la deuxième surface (12B), la quatrième fiche conductrice (312) étant disposée dans la région terminale (R2) et adjacente à la deuxième électrode capacitive (164), et la deuxième électrode capacitive (164) étant reliée électriquement à la quatrième fiche conductrice (312) par l'intermédiaire d'une couche de fil métallique (322) prévue au-dessus de la deuxième fiche conductrice (314) et de la quatrième fiche conductrice (312).
